# EUROPÄISCHE PATENTSCHRIFT

(11) **EP 3 778 469 B1**
(45) Veröffentlichungstag und Bekanntmachung des Hinweises auf die Patenterteilung: **22.02.2023**
(21) Anmeldenummer: 19192135.2
(22) Anmeldetag: 16.08.2019
(51) Int. Cl.: B81B 3/00

(54) **MEMS-BAUTEIL, BAUGRUPPE MIT DEM MEMS-BAUTEIL UND VERFAHREN ZUM BETREIBEN DES MEMS-BAUTEILS**
MEMS COMPONENT, ASSEMBLY COMPRISING THE MEMS COMPONENT AND METHOD FOR OPERATING THE MEMS COMPONENT
COMPOSANT MEMS, MODULE DOTÉ DU COMPOSANT MEMS ET PROCÉDÉ DE FONCTIONNEMENT DU COMPOSANT MEMS

(43) Veröffentlichungstag der Anmeldung: 17.02.2021
(73) Patentinhaber: Fraunhofer-Gesellschaft zur Förderung der angewandten Forschung e.V., 80686 München (DE)
(72) Erfinder: Kaiser, Bert, 01689 Weinböhla (DE); Monsalve Guaracao, Jorge Mario, 01097 Dresden (DE); Conrad, Holger, 01099 Dresden (DE)
(74) Vertreter: 2SPL Patentanwälte PartG mbB

(56) Entgegenhaltungen:
- US-A1- 2013 243 234
- US-A1- 2015 078 590
- US-A1- 2018 194 615

## Beschreibung

### Technisches Gebiet

Die vorliegende Offenbarung befasst sich mit mikromechanischen (engl. MicroElectroMechanical Systems, MEMS) Bauelementen. Insbesondere betreffen Ausführungsbeispiele ein MEMS-Bauteil, eine Baugruppe mit dem MEMS-Bauteil sowie Verfahren zum Betreiben des MEMS-Bauteils.

### Hintergrund

MEMS-Bauelemente können auf vielfache Weise genutzt werden, um mit einem Gas oder einer Flüssigkeit in der Umgebung zu interagieren. Beispielsweise können MEMS-Bauelemente genutzt werden, um ein Gas in der Umgebung zu Schwingungen anzuregen. Derartige MEMS-Bauelemente können beispielsweise für Lautsprecher verwendet werden. Auch können MEMS-Bauelemente genutzt werden, um Schwingungen eines Gases in der Umgebung zu detektieren. Derartige MEMS-Bauelemente können beispielsweise für Mikrofone verwendet werden.

So schlagen etwa die Dokumente US 2018/194615 A1 und US 2018/290883 A1 ineinandergreifende Strukturen vor, die mittels eines angelegten Potentials auslenkbar sind, um eine Kraft in eine Membran einzuleiten, so dass die Membran eine Auslenkung erfährt. Die kammartigen Antriebsstrukturen sind dabei um die Membran herum angeordnet. Die kammartigen Antriebsstrukturen sind dabei als aktive Aktuatoren (Aktoren) ausgebildet, die sich aus der Ebene heraus (engl. out-of-plane) bewegen, um die Membran in Schwingung zu versetzen.

Eine Bewegung in der Ebene (engl. in-plane) eines passiven Elements, das durch mikromechanische Aktuatoren angetrieben wird, wird in Dokument DE 10 2017 206 766 A1 vorgeschlagen. Dabei sind auslenkbare Elemente gegenüberliegend einseitig mit einem umgebenden Substrat verbunden. Die jeweiligen frei beweglichen Enden sind mit Platten über Federelemente oder starre Elemente verbunden und können so Kräfte auf die Platte übertragen. Mindestens zwei solcher Platten sind gegenüberliegend angeordnet und schließen seitlich eine Kavität ab, die mit der Umgebung durch eine Öffnung im Substrat verbunden ist. Nachteilig daran ist, dass die Platten nicht für ausreichend große Volumina geeignet sind. Eine kammartige Struktur, die der Bewegung von Mikrospiegeln dient und sich in der Ebene bewegt, wird in Dokument DE 10 2008 049 647 A1 vorgeschlagen. Die kammfingerartigen Antriebskomponenten sind flexibel mit einem beweglichen Funktionselement verbunden. Das Funktionselement ist so durch die Antriebskomponenten verformbar. Alternativ sind die Verformungen des Funktionselementes messbar. Die Bewegung der Elektroden erfolgt in der Ebene. Nachteilig daran ist, dass hohe Kapazitäten für die Auslenkung notwendig sind.

Dokument DE 10 2017 220 412 A1 schlägt ferner einen Sensor vor, der durch kammartig angeordnete Elektroden gebildet ist. Dabei sind erste Elektroden mit einer Masse und zweite Elektroden mit einem umgebenden Substrat verbunden. Die Elektroden überlappen sich in einem nicht ausgelenktem Zustand um weniger als 35%, bevorzugt aber um weniger als 25%. Die Bewegung der Elektroden erfolgt aus der Ebene heraus.

US 2013/243234 und US 2015/078590 beschreiben MEMS-Sensoren, bei denen eine sich bewegende Membran fingerartige Strukturen aufweist, die sich in Teilkavitäten bewegen können, die in einer Schicht der MEMS-Komponente gebildet sind. Große Druckschwankungen in diesen Teilkavitäten durch die Bewegung der Membran werden durch Öffnungen zur Umgebung verhindert und diese sorgen für einen Druckausgleich in der Sensoreinrichtung.

Wünschenswert wäre ein MEMS-Element, das eine Vergrößerung der wirksamen Fläche des MEMS-Elements zur Interaktion mit einem umgebenden Fluid (Umgebungsfluid) ermöglicht. Ferner sollten Bewegungen für die Interaktion mit dem Umgebungsfluid in der Ebene, d.h. in-plane, erfolgen.

Vor diesem Hintergrund ist es eine Aufgabe, eine verbesserte MEMS-Struktur zur Interaktion mit einem Umgebungsfluid bereitzustellen.

### Zusammenfassung

Die Aufgabe wird erfindungsgemäß durch ein MEMS-Bauteil, eine Baugruppe mit dem MEMS-Bauteil sowie Verfahren zum Betreiben des MEMS-Bauteils gemäß den unabhängigen Ansprüchen gelöst. Weitere Aspekte sowie Weiterbildungen der Erfindung sind in den abhängigen Ansprüchen, der folgenden Beschreibung sowie in den Figuren beschrieben.

Ein erstes Ausführungsbeispiel betrifft ein MEMS-Bauteil umfassend einen Schichtstapel mit zumindest einer zwischen einer ersten Schicht und einer dritten Schicht gebildeten zweiten Schicht. In der zweiten Schicht ist eine Kavität gebildet. Das MEMS-Bauteil umfasst ferner zwei lateral auslenkbare Elemente, die lateral zueinander beabstandet in der Kavität angeordnet sind. Jedes der zwei lateral auslenkbaren Elemente weist jeweils ein mit einer Seitenwand der Kavität verbundenes Ende auf. Weiterhin umfasst das MEMS-Bauteil ein Verbindungselement, das mit den zwei lateral auslenkbaren Elementen verbunden ist, um die Bewegung der zwei lateral auslenkbaren Elemente zu koppeln. Eine Mehrzahl an ersten Fingern sind diskret zueinander beabstandet zwischen den zwei lateral auslenkbaren Elementen an der Seitenwand der Kavität angeordnet. Zudem ist eine Mehrzahl an zweiten Fingern diskret zueinander beabstandet zwischen den zwei lateral auslenkbaren Elementen an dem Verbindungselement angeordnet. Die Mehrzahl an zweiten Fingern greifen mit der Mehrzahl an ersten Fingern ineinander. Weiterhin sind die Mehrzahl an zweiten Fingern lateral gegenüber der Mehrzahl an ersten Fingern bei Verformung der zwei lateral auslenkbaren Elemente verschiebbar, so dass die Mehrzahl an ersten Fingern und die Mehrzahl an zweiten Fingern eine Mehrzahl an volumenveränderlichen Teilkavitäten innerhalb der Kavität begrenzen. Jede der Mehrzahl an Teilkavitäten steht über eine jeweilige Öffnung mit einem Umgebungsfluid des MEMS-Bauteils in Kontakt. Bei benachbarten Teilkavitäten der Mehrzahl an Teilkavitäten ist jeweils die Öffnung der einen Teilkavität der benachbarten Teilkavitäten in einer anderen Schicht der ersten Schicht, der zweiten Schicht und der dritten Schicht als die Öffnung der anderen Teilkavität der benachbarten Teilkavitäten gebildet.

Ferner betrifft ein zweites Ausführungsbeispiel eine Baugruppe umfassend eine Mehrzahl an hierin beschriebenen MEMS-Bauteilen. Zudem umfasst die Baugruppe eine Steuerschaltung, die eingerichtet ist, zumindest ein erstes Potential für die lateral auslenkbaren Elemente zumindest eines Teils der Mehrzahl an MEMS-Bauteilen bereitzustellen, um die jeweiligen lateral auslenkbaren Elemente als Aktoren zur Beeinflussung des Umgebungsfluid zu betreiben. Alternativ oder ergänzend umfasst die Baugruppe eine Messschaltung, die eingerichtet ist, zweite Potentiale der jeweiligen lateral auslenkbaren Elemente zumindest eines Teils der Mehrzahl an MEMS-Bauteilen zu messen, um die jeweiligen lateral auslenkbaren Elemente als Sensoren für das Umgebungsfluid zu betreiben.

Ein drittes Ausführungsbeispiel betrifft ein erstes Verfahren zum Betreiben eines hierin beschriebenen MEMS-Bauteils. Das Verfahren umfasst ein laterales Verformen der zwei lateral auslenkbaren Elemente in eine erste Richtung durch Anlegen eines Potentials, um während eines ersten Zeitintervalls zur Beeinflussung des Umgebungsfluides ein Volumen der einen Teilkavität der benachbarten Teilkavitäten zu vergrößern und ein Volumen der anderen Teilkavität der benachbarten Teilkavitäten zu verringern. Weiterhin umfasst das Verfahren ein laterales Verformen der zwei lateral auslenkbaren Elemente in eine entgegengesetzte zweite Richtung durch Anlegen des Potentials, um während eines zweiten Zeitintervalls zur Beeinflussung des Umgebungsfluides das Volumen der einen Teilkavität der benachbarten Teilkavitäten zu vergrößern und das Volumen der anderen Teilkavität der benachbarten Teilkavitäten zu verringern.

Weiterhin betrifft ein viertes Ausführungsbeispiel ein zweites Verfahren zum Betreiben eines hierin beschriebenen MEMS-Bauteils, bei dem sich die Mehrzahl an zweiten Fingern gegenüber der Mehrzahl an ersten Fingern lateral verschieben können, um abhängig von dem Umgebungsfluid Volumina der benachbarten Teilkavitäten unter lateraler Verformung der zwei lateral auslenkbaren Elemente einzustellen. Das Verfahren umfasst ein Ausgeben eines jeweiligen Potentials durch die zwei lateral auslenkbaren Elemente bei lateraler Verformung aufgrund der äußeren Krafteinwirkung durch die Verschiebung der Mehrzahl an zweiten Fingern.

Die zwischen den ersten und den zweiten Fingern gebildeten Teilkavitäten bilden eine große Fläche für die Interaktion mit dem Umgebungsfluid. Das MEMS-Bauteil kann dabei sowohl zur Beeinflussung des Umgebungsfluides, d.h. als Aktor, als auch zur Vermessung des Umgebungsfluides, d.h. als Sensor, genutzt werden. Die zur Verfügung stehende Fläche des MEMS-Bauteils kann somit zu einem hohen Grad für die Interaktion mit dem Umgebungsfluid genutzt werden. Zudem ermöglichen die kammartigen Anordnungen der ersten und zweiten Finger, dass nur ein vergleichsweise geringer (ungewollter) elektrischer Kapazitätsbelag erfolgt.

### Figurenkurzbeschreibung

Einige Beispiele von Vorrichtungen und/oder Verfahren werden nachfolgend bezugnehmend auf die beiliegenden Figuren lediglich beispielhaft näher erläutert. Es zeigen:
Fig. 1 eine Draufsicht auf ein erstes Ausführungsbeispiel eines MEMS-Bauteil;
Fig. 2 einen Schnitt durch das erste Ausführungsbeispiel des MEMS-Bauteils;
Fig. 3 eine Draufsicht auf ein zweites Ausführungsbeispiel eines MEMS-Bauteil;
Figs. 4 bis 6 Ausführungsbeispiele geometrischer Verhältnisse der ersten Finger und der zweiten Finger;
Fig. 7 eine Draufsicht auf ein drittes Ausführungsbeispiel eines MEMS-Bauteil;
Fig. 8 eine Draufsicht auf ein viertes Ausführungsbeispiel eines MEMS-Bauteil;
Fig. 9 eine Draufsicht auf ein fünftes Ausführungsbeispiel eines MEMS-Bauteil;
Figs. 10 und 11 ein Ausführungsbeispiel einer Bewegung eines sechsten MEMS-Bauteils;
Fig. 12 eine Draufsicht auf ein siebtes Ausführungsbeispiel eines MEMS-Bauteil;
Fig. 13 ein Ausführungsbeispiel einer Baugruppe mit einer Mehrzahl an MEMS-Bauteilen;
Figs. 14 bis 17 Ausführungsbeispiele für die Anordnung der MEMS-Bauteile innerhalb der Baugruppe;
Fig. 18 ein Ablaufdiagramm eines ersten Ausführungsbeispiels eines Verfahrens zum Betreiben eines MEMS-Bauteils; und
Fig. 19 ein Ablaufdiagramm eines zweiten Ausführungsbeispiels eines Verfahrens zum Betreiben eines MEMS-Bauteils.

### Beschreibung

Verschiedene Beispiele werden nun ausführlicher Bezug nehmend auf die beiliegenden Figuren beschrieben, in denen einige Beispiele dargestellt sind. In den Figuren können die Stärken von Linien, Schichten und/oder Bereichen zur Verdeutlichung übertrieben sein.

Während sich weitere Beispiele für verschiedene Modifikationen und alternative Formen eignen, sind dementsprechend einige bestimmte Beispiele derselben in den Figuren gezeigt und werden nachfolgend ausführlich beschrieben. Allerdings beschränkt diese detaillierte Beschreibung weitere Beispiele nicht auf die beschriebenen bestimmten Formen. Weitere Beispiele können alle Modifikationen, Entsprechungen und Alternativen abdecken, die in den Rahmen der Offenbarung fallen. Gleiche oder ähnliche Bezugszeichen beziehen sich in der gesamten Beschreibung der Figuren auf gleiche oder ähnliche Elemente, die bei einem Vergleich miteinander identisch oder in modifizierter Form implementiert sein können, während sie die gleiche oder eine ähnliche Funktion bereitstellen.

Es versteht sich, dass, wenn ein Element als mit einem anderen Element "verbunden" oder "gekoppelt" bezeichnet wird, die Elemente direkt, oder über ein oder mehrere Zwischenelemente, verbunden oder gekoppelt sein können. Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht explizit oder implizit anders definiert. Eine alternative Formulierung für die gleichen Kombinationen ist "zumindest eines von A und B" oder "A und/oder B". Das Gleiche gilt, mutatis mutandis, für Kombinationen von mehr als zwei Elementen.

Die Terminologie, die hier zum Beschreiben bestimmter Beispiele verwendet wird, soll nicht begrenzend für weitere Beispiele sein. Wenn eine Singularform, z. B. "ein, eine" und "der, die, das" verwendet wird und die Verwendung nur eines einzelnen Elements weder explizit noch implizit als verpflichtend definiert ist, können weitere Beispiele auch Pluralelemente verwenden, um die gleiche Funktion zu implementieren. Wenn eine Funktion nachfolgend als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei Gebrauch das Vorhandensein der angegebenen Merkmale, Ganzzahlen, Schritte, Operationen, Prozesse, Elemente, Komponenten und/oder einer Gruppe derselben präzisieren, aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

Sofern nicht anderweitig definiert, werden alle Begriffe (einschließlich technischer und wissenschaftlicher Begriffe) hier in ihrer üblichen Bedeutung auf dem Gebiet verwendet, zu dem Beispiele gehören.

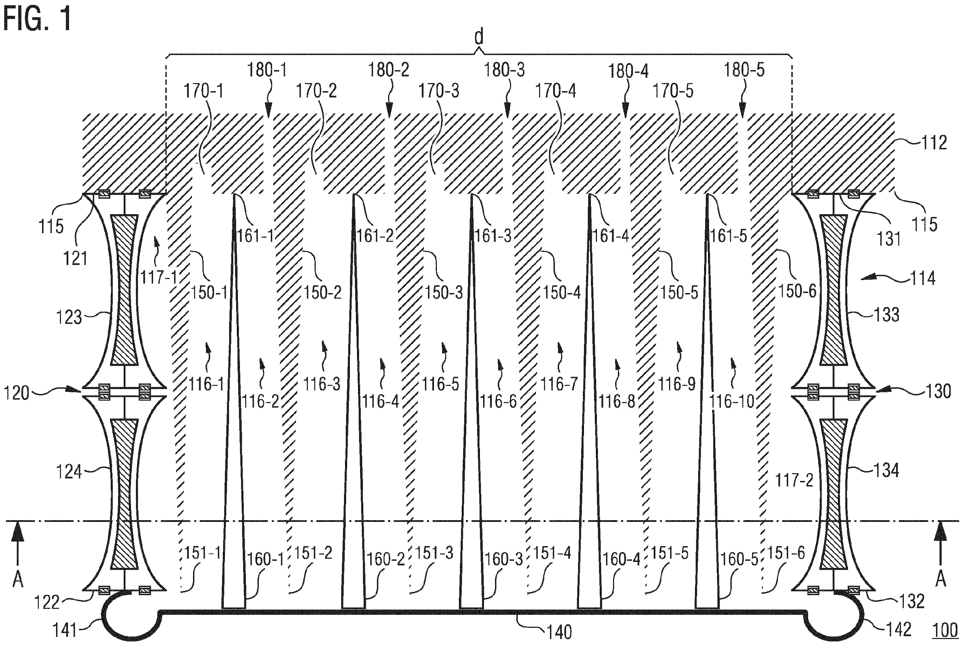

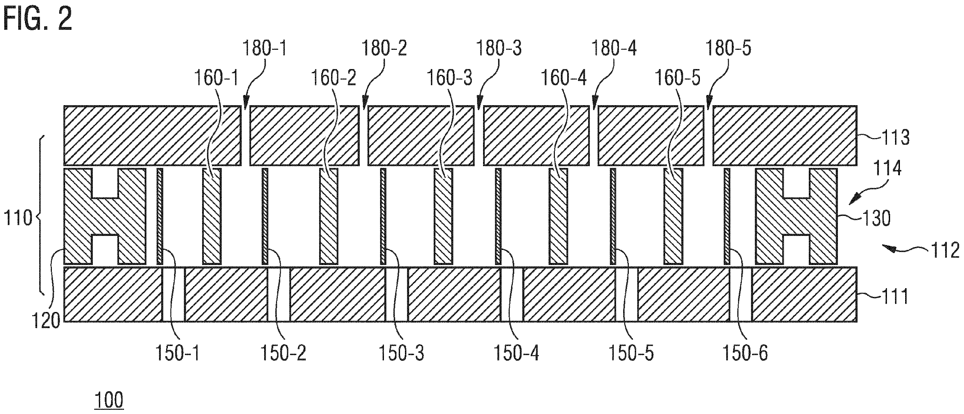

**Fig. 1** zeigt eine Draufsicht auf ein erstes MEMS-Bauteil 100. Insbesondere zeigt Fig. 1 eine Draufsicht auf eine zweite Schicht 112 eines Schichtstapels 110, aus dem das MEMS-Bauteil 100 aufgebaut ist. Der Aufbau des Schichtstapels 110 ist aus **Fig. 2** ersichtlich, in der eine Schnittansicht des MEMS-Bauteils 100 entlang der in Fig. 1 angedeuteten Schnittlinie A-A dargestellt ist.

Aus Fig. 2 ist ersichtlich, dass der Schichtstapel 110 zumindest eine erste Schicht 111, die zweite Schicht 112 und eine dritte Schicht 113 umfasst. Die zweite Schicht 112 ist dabei zwischen der ersten Schicht 111 und der dritten Schicht 113 gebildet. In der zweiten Schicht 112 ist eine Kavität 114 gebildet, in der die weiteren Elemente des MEMS-Bauteils 100 angeordnet sind. Die zweite Schicht 112 kann daher auch als eine Substratschicht aufgefasst werden.

Die erste Schicht 111 dient als Bodenschicht für die zweite Schicht 112. Die dritte Schicht 113 dient als Deckelschicht für die zweite Schicht 112. Die erste Schicht 111 und die dritte Schicht 113 begrenzen die Kavität 114 entlang der Dickenrichtung des Schichtstapels 110.

Die Schichten 111 bis 113 können elektrisch leitfähige Materialien aufweisen wie etwa dotierte Halbleitermaterialien (z.B. dotiertes Silizium) oder Metallmaterialien. Die schichtweise Anordnung elektrisch leitfähiger Schichten ermöglicht eine einfache Ausgestaltung bzw. Strukturierung, da durch selektives Herauslösen von Material aus der jeweiligen Schicht aktive Elemente (z.B. Elektroden) wie auch passive Elemente gebildet werden können. Ebenso können die Schichten 111 bis 113 elektrisch nicht-leitfähige Materialien aufweisen. Die elektrisch nicht-leitfähigen Materialien können beispielsweise mittels Abscheideverfahren in einer der Schichten 111 bis 113 eingebracht werden.

Beispielsweise können die erste Schicht 111, die zweite Schicht 112 und die dritte Schicht 113 jeweils ein Wafer sein. Die einzelnen Wafer sind über stoffschlüssige Verfahren (z.B. Bonden) jeweils paarweise miteinander verbunden, um den Schichtstapel 110 mit der oben beschriebenen Schichtenfolge zu erhalten. Entsprechend kann die Kavität 114 als ein akustisch abgedichteter Zwischenraum in dem MEMS-Bauteil 100 ausgebildet werden.

In der Kavität 114 sind zwei lateral auslenkbare Elemente 120 und 130 lateral zueinander beabstandet angeordnet. Der Begriff "lateral auslenkbar" ist dabei so zu verstehen, dass die zwei Elemente 120 und 130 in der Lage sind, eine Bewegung in der Ebene der zweiten Schicht 112, d.h. eine in-plane Bewegung, durchzuführen. Mit anderen Worten: Die zwei lateral auslenkbaren Elemente 120 und 130 können sich innerhalb der Ebene der zweiten Schicht 112, jedoch nicht vertikal zur Ebene der zweiten Schicht 112 (d.h. aus der Ebene der zweiten Schicht 112 heraus) bewegen. Ein lateraler Abstand d zwischen den lateral auslenkbaren Elemente 120 und 130 kann z.B. mindestens 2 µm und maximal 4 mm betragen. Gemäß Ausführungsbeispielen kann der Abstand d beispielsweise 320 µm oder 500 µm betragen.

Jedes der zwei lateral auslenkbaren Elemente 120 und 130 weist jeweils ein mit einer Seitenwand 115 der Kavität 114 verbundenes Ende 121 bzw. 131 auf. Bei dem in Figs. 1 und 2 dargestellten MEMS-Bauteil weist jedes der zwei lateral auslenkbaren Elemente 120 und 130 ferner ein freies Ende (bzw. ein frei bewegliches Ende) 122 bzw. 132 auf.

Die lateral auslenkbaren Elemente 120 und 130 können verschiedenartig ausgebildet bzw. aufgebaut sein. Unabhängig vom konkreten Aufbau der lateral auslenkbaren Elemente 120 und 130 sind diese ausgebildet, sich bei Anlegen eines ersten Potentials (z.B. eines ersten Spannungssignals) lateral zu verformen und/oder bei lateraler Verformung aufgrund einer äußeren Krafteinwirkung jeweils ein zweites Potential (z.B. ein zweites Spannungssignal auszugeben). Mit anderen Worten: Die lateral auslenkbaren Elemente 120 und 130 sind ausgebildet, um ansprechend auf eine Aktuierung aufgrund der Befestigung an der Seitenwand der Kavität 114 eine in eine Bewegung umgewandelte Kraft bereitzustellen (d.h. als Aktor zu wirken) und/oder um eine Verformung zu erfassen (d.h. als Sensor zu wirken). Beispielsweise können die lateral auslenkbaren Elemente 120 und 130 als elektromechanische Wandler, piezoelektrische Wandler, magnetostriktiver Wandler, thermomechanischer Wandler oder eine Kombination daraus ausgebildet sein, um die jeweilige Energieform bzw. das jeweilige Potential in mechanische Energie zu wandeln und umgekehrt. Entsprechend kann jedes der zwei lateral auslenkbaren Elemente 120 und 130 z.B. als elektrostatische, piezoelektrische, magnetostriktive und/oder thermomechanische Elektrode ausgebildet sein.

Basierend auf einem jeweils angelegten Potential kann so eine entsprechende Verformung der lateral auslenkbaren Elemente 120 und 130 in der Ebene der zweiten Schicht 112 bereitgestellt werden bzw. bei lateraler Verformung aufgrund einer äußeren Krafteinwirkung durch jedes der lateral auslenkbaren Elemente 120 und 130 ein entsprechendes Potential bereitgestellt werden.

Die in Figs. 1 und 2 dargestellten lateral auslenkbaren Elemente 120 und 130 sind als elektrostatische Elektroden ausgebildet und weisen einander gegenüberliegende, erste und zweite auslenkbare bzw. lateral verformbare Teilelemente 123 und 124 bzw. 133 und 134 auf, die voneinander beabstandet und elektrisch miteinander verbunden sind. Die lateral verformbaren Teilelemente 123 und 124 bzw. 133 und 134 weisen dabei jeweils eine konkav gekrümmte Form auf. Jedes der lateral verformbaren Teilelemente 123 und 124 bzw. 133 und 134 ist im einfachsten Fall dreischichtig aufgebaut mit zwei geometrisch unterschiedlich ausgebildeten Elektrodenschichten, die über eine nichtleitende Schicht, die unterbrochen sein kann, miteinander verbunden sind. Bei Anlegen eines Potentials zwischen den zumindest zwei Elektrodenschichten wird ein elektrisches Feld aufgespannt, infolge dessen sich die Elektrodenschichten (z.B. unter Veränderung ihrer Länge) lateral verformen. Aufgrund der mechanischen Fixierung der lateral auslenkbaren Elemente 120 und 130 an der Seitenwand der Kavität 114 sind die Freiheitsgrade der resultierenden Verformung eingegrenzt, so dass eine Verformung (Verkrümmung bzw. Auslenkung) in der Ebene der zweiten Schicht 112 erfolgt. Die Verwendung jeweils zweier lateral verformbarer Teilelemente 123 und 124 bzw. 133 und 134 für die lateral auslenkbaren Elemente 120 und 130 ermöglicht eine hohe und einstellbare Linearität der lateral auslenkbaren Elemente 120 und 130.

Auslenkbare Elemente und insbesondere lateral auslenkbare Elemente, die zumindest eine erste Elektrodenschicht und eine zweite Elektrodenschicht, zwischen denen eine nicht-leitende Schicht ausgebildet ist, umfassen, sind auch als nanoskopische elektrostatische Antriebe (engl. Nanoscopic Electrostatic Drive, NED) bekannt. Ausführungsbeispiele für NEDs sind in den Patentanmeldungen WO 2012/095185 A1, WO 2016/202790 A2 und DE 10 215/206 774 A1 der Fraunhofer-Gesellschaft zur Förderung der angewandten Wissenschaften beschrieben, deren Inhalt hiermit in diese Anmeldung aufgenommen wird. Laterale NEDs (L-NEDs) verformen sich lateral bei Anlegen eines ersten Spannungssignals an die erste Elektrodenschicht und die zweite Elektrodenschicht. Ferner erzeugen L-NEDs bei lateraler Verformung aufgrund einer äußeren Krafteinwirkung ein zweites Spannungssignal an der ersten Elektrodenschicht und der zweiten Elektrodenschicht. Die lateral auslenkbaren Elemente 120 und 130 können somit gemäß einigen Ausführungsbeispielen als NEDs ausgebildet sein.

Wie aus den weiteren Ausführungsbeispielen ersichtlich sein wird, ist die Form der lateral auslenkbaren Elemente 120 und 130 nicht auf die in Fig. 1 gezeigte, konkav gekrümmte Form beschränkt. Grundsätzlich kann die Form der lateral auslenkbaren Elemente 120 und 130 beliebig sein (z.B. balkenartig, dachartig, etc.).

Ein Verbindungselement 140 ist mit den zwei lateral auslenkbaren Elementen 120 und 130 verbunden, um die Bewegung der zwei lateral auslenkbaren Elemente 120 und 130 zu koppeln. Bei dem in Fig. 1 dargestellten MEMS-Bauteil 100 ist das Verbindungselement 140 mit den freien Enden 122 und 132 der zwei lateral auslenkbaren Elemente 120 und 130 verbunden. Das Verbindungselement 140 ist dabei jeweils über ein flexibles Element 141 bzw. 142 mit den zwei lateral auslenkbaren Elementen 120 und 130 verbunden. Das flexible Element 141 bzw. 142 weist eine geringere Steifigkeit als das Verbindungselement 140 und die zwei lateral auslenkbaren Elemente 120 und 130 auf. Derart sind die lateral auslenkbaren Elemente 120 und 130 nicht starr mit dem Verbindungselement 140 verbunden, so dass die bei der Verformung der lateral auslenkbaren Elementen 120 und 130 auftretenden Zugkräfte minimiert werden können. Die flexible Elemente 141 bzw. 142 können als Federelemente angesehen werden, da sie eine geringere Steifigkeit als das Verbindungselement 140 und die zwei lateral auslenkbaren Elemente 120 und 130 aufweisen. Gemäß einigen Ausführungsbeispielen können die flexiblen Elementen 141und 142 auch weggelassen werden.

Eine Mehrzahl an ersten Fingern 150-1, ..., 150-6 sind diskret zueinander beabstandet zwischen den zwei lateral auslenkbaren Elementen 120 und 130 an der Seitenwand 115 der Kavität 114 angeordnet. Ferner ist eine Mehrzahl an zweiten Fingern 160-1, ..., 160-5 diskret zueinander beabstandet zwischen den zwei lateral auslenkbaren Elementen 120 und 130 an dem Verbindungselement 140 angeordnet. Dabei ist zu beachten, dass die Anzahlen der ersten Finger und der zweiten Finger in Fig. 1 rein willkürlich zur Erläuterung der Funktion des MEMS-Bauteils 100 gewählt sind. Grundsätzlich kann jede Mehrzahl an ersten Finger und der zweiten Finger gewählt werden. Beispielsweise kann die Anzahl an ersten Fingern zwischen 1 und 50, insbesondere 10 oder 20, betragen. Die Anzahl an zweiten Fingern kann z.B. zwischen 2 und 51, insbesondere 11 oder 21, betragen.

Der jeweilige laterale Abstand zwischen der Mehrzahl an ersten Fingern 150-1, ..., 150-6 als auch der jeweilige laterale Abstand zwischen der Mehrzahl an zweiten Fingern 160-1, ..., 160-5 beträgt beispielsweise zwischen 0 und 100 µm (d.h. 100 µm oder weniger), insbesondere 10 µm oder 15 µm.

Eine Erstreckung (d.h. die Höhe) der Mehrzahl an ersten Fingern 150-1, ..., 150-6, der Mehrzahl an zweiten Fingern 160-1, ..., 160-5 als auch der zwei lateral auslenkbaren Elemente 120 und 130 kann gemäß Ausführungsbeispielen entlang der Dickenrichtung der zweiten Schicht 112 (bzw. des Schichtstapels 110) jeweils zwischen 10 µm und 750 µm betragen.

Ein Verhältnis der Erstreckung der Mehrzahl an ersten Fingern 150-1, ..., 150-6 und/oder der Erstreckung der Mehrzahl an zweiten Fingern 160-1, ..., 160-5 entlang der Dickenrichtung der zweiten Schicht 112 zu der Erstreckung der zwei lateral auslenkbaren Elemente 120 und 130 entlang der Dickenrichtung der zweiten Schicht beträgt gemäß Ausführungsbeispielen zwischen 10 % und 100 %. Mit anderen Worten: Das Verhältnis der Höhe der lateral auslenkbaren Elemente 120 und 130 zur Höhe eines der Mehrzahl an ersten Fingern 150-1, ..., 150-6 bzw. zur Höhe eines der Mehrzahl an zweiten Fingern 160-1, ..., 160-5 beträgt zwischen 10 % und 100 %.

Die Mehrzahl an zweiten Fingern 160-1, ..., 160-5 greifen mit der Mehrzahl an ersten Fingern 150-1, ..., 150-6 ineinander. Die Mehrzahl an zweiten Fingern 160-1, ..., 160-5 und die Mehrzahl an ersten Fingern 150-1, ..., 150-6 überlappen sich dabei entlang ihrer Längserstreckung um zumindest 65 %, 85 % oder 95 %. Ferner überlappen sich Mehrzahl an zweiten Fingern 160-1, ..., 160-5 und die Mehrzahl an ersten Fingern 150-1, ..., 150-6 entlang der Dickenrichtung der zweiten Schicht 112 (bzw. des Schichtstapels 110) um zumindest 80 %, 90% oder 99 %.

Die Mehrzahl an zweiten Fingern 160-1, ..., 160-5 und die Mehrzahl an ersten Fingern 150-1, ..., 150-6 bilden so Teilkavitäten 116-1, ..., 116-10 innerhalb der Kavität 114. Lateral sind die Teilkavitäten 116-1, ..., 116-10 durch die Seitenwand 115 der Kavität 114, das Verbindungselement 115, sowie jeweils durch einen der Mehrzahl an ersten Fingern 150-1, ..., 150-6 sowie einen der Mehrzahl an zweiten Fingern 160-1, ..., 160-5 begrenzt. In vertikaler Richtung, d.h. entlang der Dickrichtung des Schichtstapels 110, sind die Teilkavitäten 116-1, ..., 116-10 durch die erste Schicht 111 (als Bodenschicht) und die dritte Schicht 113 (als Deckelschicht) begrenzt.

Die Mehrzahl an zweiten Fingern 160-1, ..., 160-5 sind lateral gegenüber der Mehrzahl an ersten Fingern 150-1, ..., 150-6 bei (unter) Verformung der zwei lateral auslenkbaren Elemente 120 und 130 verschiebbar (d.h. entlang einer Raumrichtung senkrecht zur Längserstreckung der Mehrzahl an zweiten Fingern 160-1, ..., 160-5). Der laterale Abstand zwischen einem zweiten Finger der Mehrzahl an zweiten Fingern 160-1, ..., 160-5 und einem benachbarten ersten Finger der Mehrzahl an ersten Fingern 150-1, ..., 150-6 ist somit veränderlich, so dass über die laterale Bewegung der Mehrzahl an zweiten Fingern 160-1, ..., 160-5 die Volumina der Teilkavitäten 116-1, ..., 116-10 verändert werden können. Die Mehrzahl an ersten Fingern 150-1, ..., 150-6 und die Mehrzahl an zweiten Fingern 160-1, ..., 160-5 begrenzen somit eine Mehrzahl an volumenveränderlichen Teilkavitäten 116-1, ..., 116-10 innerhalb der Kavität 114.

Jede der Mehrzahl an Teilkavitäten 116-1, ..., 116-10 steht über eine jeweilige Öffnung 170-1, ..., 170-5 bzw. 180-1, ..., 180-5 mit einem Umgebungsfluid (z.B. ein Gas oder Flüssigkeit), welches das MEMS-Bauteil 100 umgibt, in Kontakt. Bei benachbarten Teilkavitäten der Mehrzahl an Teilkavitäten 116-1, ..., 116-10 ist die Öffnung der einen Teilkavität der benachbarten Teilkavitäten in einer anderen Schicht des Schichtstapels 110 als die Öffnung der anderen Teilkavität der benachbarten Teilkavitäten gebildet. Bei dem in Fig. 1 gezeigten MEMS-Bauteil ist die Öffnung 170-1 der Teilkavität 116-1 in der ersten Schicht 111 oder der dritten Schicht 113 gebildet (womit die Teilkavität 116-1 über die Aussparung/Ausbuchtung in der Seitenwand 115 gekoppelt/verbunden ist). Die Öffnung 180-1 der benachbarten Teilkavität 116-2 ist in der zweiten Schicht 112 gebildet. Die Öffnung 170-2 der zu der Teilkavität 116-2 benachbarten Teilkavität 116-3 ist wiederum in der ersten Schicht 111 oder der dritten Schicht 113 gebildet (womit die Teilkavität 116-3 über die Aussparung/Ausbuchtung in der Seitenwand 115 gekoppelt/verbunden ist). Für die Schnittansicht der Fig. 2 wurde angenommen, dass die Öffnung 170-1, ..., 170-5 in der dritten Schicht 113 gebildet sind. Wie oben beschrieben, können die Öffnung 170-1, ..., 170-5 alternativ auch in der ersten Schicht 111 gebildet sein.

Zwei weitere Teilkavitäten 117-1 und 117-2 sind zwischen dem ersten bzw. dem letzten der Mehrzahl an ersten Fingern 150-1, ..., 150-6 sowie einem jeweiligen der zwei lateral verformbaren Elemente 120 und 130 gebildet. Bauartbedingt weisen die weiteren Teilkavitäten 117-1 und 117-2 andere Berandungen als die Teilkavitäten 116-1, ..., 116-10 auf. Auch die Teilkavitäten 117-1 und 117-2 sind über entsprechende Öffnungen (in Figs. 1 und 2 jeweils nicht dargestellt) mit der Umgebung des MEMS-Bauteils 100 verbunden. Im Gegensatz zu den Teilkavitäten 116-1, ..., 116-10 sind die Teilkavitäten 117-1 und 117-2 nicht jeweils durch einen ersten Finger und einen zweiten Finger, sondern jeweils durch einen der ersten Finger 150-1 und 150-6 sowie eines der lateral verformbaren Elemente 120 und 130 begrenzt.

Die in der zweiten Schicht 112 und beabstandet zueinander ausgebildeten lateral auslenkbaren Elemente 120 und 130 sind an jeweils einem Ende (bzw. einer Seite) mit dem Substrat der zweiten Schicht 112 verbunden. Das Verbindungselement 140 zusammen mit der daran gebildeten Mehrzahl an zweiten Fingern 160-1, ..., 160-5 bildet ein kammartiges Element, welches in die Gegenfinger bildende Mehrzahl an ersten Fingern 150-1, ..., 150-6 eingreift. Das Verbindungselement 140 kann daher als eine Art Kammrücken verstanden werden, an dem Kammfinger in Form der Mehrzahl an zweiten Fingern 160-1, ..., 160-5 gebildet sind. Das den Kammrücken bildende Verbindungselement 140, die federnden Elemente 141 und 142 als auch die Kammfinger bildende Mehrzahl an zweiten Fingern 160-1, ..., 160-5 sind passive Elemente, welche den Bewegungen der lateral auslenkbaren Elemente 120 und 130 folgen. Die die Gegenfinger bildende Mehrzahl an ersten Fingern 150-1, ..., 150-6 sind mit dem Substrat der zweiten Schicht 112 fest verbunden und weisen frei Enden 151-1, ..., 151-6 (die nicht gekoppelt bzw. eingespannt sind) auf.

Die freien Enden 151-1, ..., 151-6 der Mehrzahl an ersten Fingern 150-1, ..., 150-6 sind von dem Kammrücken bzw. dem Verbindungselement 140 derart beabstandet, dass eine Bewegung des Kammrückens bzw. des Verbindungselements 140 nicht behindert und gleichzeitig der Abstand eines jeden der Mehrzahl an ersten Fingern 150-1, ..., 150-6 zu dem Verbindungselement 140 so gering ist, dass ein (signifikanter) Volumenstrom des Umgebungsfluides durch den zwischen dem Verbindungselement 140 und dem jeweiligen Finger der Mehrzahl an ersten Fingern 150-1, ..., 150-6 gebildeten Freiraum nicht möglich ist. Mit anderen Worten: Zwischen jedem der Mehrzahl an ersten Fingern 150-1, ..., 150-6 und dem Verbindungselement 140 ist jeweils ein (kleiner) Spalt gebildet, dessen Abmessungen so gering sind, dass durch den Spalt kein (signifikanter) Volumenstrom aus bzw. in eine benachbarte Teilkavität möglich ist.

Die freien Enden 161-1, ..., 161-5 der Mehrzahl an zweiten Fingern 160-1, ..., 160-5 sind bezgl. der Seitenwand 115 der Kavität 114 bzw. des Substrats der zweiten Schicht 112 entsprechend ausgebildet. Der Abstand zwischen einem jeden der freien Enden 161-1, ..., 161-5 der Mehrzahl an zweiten Fingern 160-1, ..., 160-5 und der Seitenwand 115 der Kavität 114 bzw. dem umgebenden Substrat der zweiten Schicht 112 ist derart, dass eine Bewegung der Mehrzahl an zweiten Fingern 160-1, ..., 160-5 nicht behindert wird und ein Volumenstrom des Umgebungsfluides zwischen dem jeweiligen Finger der Mehrzahl an zweiten Fingern 160-1, ..., 160-5 und der Seitenwand 115 der Kavität 114 bzw. dem umgebenden Substrat der zweiten Schicht 112 nicht möglich ist.

Durch die oben beschriebenen Ausgestaltung bzw. Positionierung der freien Enden der ersten und zweiten Finger kann ein akustischer Kurzschluss zwischen benachbarten Teilkavitäten vermieden werden.

Aufgrund der in Fig. 1 dargestellten Anordnung der Mehrzahl an ersten Fingern 150-1, ..., 150-6 sowie der Mehrzahl an zweiten Fingern 160-1, ..., 160-5 werden die zur Interkation mit dem Umgebungsfluid dienenden Teilkavitäten 116-1, ..., 116-10 in der Kavität 114 gebildet. Die Teilkavitäten sind jeweils durch einen ersten Finger, einen zweiten Finger, das Verbindungselement sowie die Seitenwand der Kavität (bzw. das umgebende Substrat zweiten Schicht 112) abgetrennt bzw. abgegrenzt. Wie bereits oben beschrieben, erfolgt aufgrund der Bewegung der Mehrzahl an zweiten Fingern 160-1, ..., 160-5 gegenüber der Mehrzahl an ersten Fingern 150-1, ..., 150-6 eine Volumenänderung der jeweiligen Teilkavität 116-1, ..., 116-10. Die Mehrzahl an zweiten Fingern 160-1, ..., 160-5 führen aufgrund ihrer Anbindung an die lateral auslenkbaren Elemente 120 und 130 mittels des Verbindungselements 140 die gleiche laterale Bewegung in der Ebene der zweiten Schicht 112 wie die lateral auslenkbaren Elemente 120 und 130 durch. Über die Öffnungen 170-1, ..., 170-5 bzw. 180-1, ..., 180-5, welche die einzelnen Teilkavitäten 116-1, ..., 116-10 jeweils mit der Umgebung des MEMS-bauteils 100 verbinden bzw. koppeln, kann ein Druckausgleich in den einzelnen Teilkavitäten 116-1, ..., 116-10 erfolgen.

Die Öffnungen in benachbarten Teilkavitäten sind dabei unterschiedlich bzw. entgegengesetzt angeordnet. Beispielsweise können die Öffnungen auch abwechselnd entweder in der ersten Schicht 111 (z.B. in Form eines Handlingwafers) oder der dritten Schicht 113 (z.B. in Form eines Deckelwafers) angeordnet sein. Befindet sich z.B. die Öffnung einer ersten der Teilkavitäten 116-1, ..., 116-10 im Bodensubstrat des Handlingwafers, so befindet sich die Öffnung der benachbarten Teilkavität im Deckelwafer des MEMS-Bauteils 100. Alternativ kann, wie in Fig. 1 dargestellt, einer der Öffnungstypen im Substrat der zweiten Schicht 112 ausgebildet sein und über die zweite Schicht 112 mit der Umgebung des MEMS-Bauteils 100 verbunden sein. Öffnungen in der zweiten Schicht 112 können eine besonders platzsparende Implementierung ermöglichen. Die Ausbildung der Öffnungen benachbarter Teilkavitäten in unterschiedlichen bzw. entgegengesetzten Schicht verhindert einen akustischen Kurzschluss zwischen den benachbarten Teilkavitäten.

Wie bereits oben ausgeführt, sind die zwei lateral auslenkbaren Elemente 120 und 130 ausgebildet, sich bei Anlegen z.B. eines ersten Spannungssignals lateral zu verformen, so dass sich die Mehrzahl an zweiten Fingern 160-1, ..., 160-5 in lateraler Richtung gegenüber der Mehrzahl an ersten Fingern 150-1, ..., 150-6 verschiebt, um zur Beeinflussung des Umgebungsfluid ein Volumen der einen Teilkavität der benachbarten Teilkavitäten abwechselnd zu verringern und zu vergrößern und umgekehrt ein Volumen der anderen Teilkavität der benachbarten Teilkavitäten abwechselnd zu vergrößern bzw. zu verringern. Beispielsweise wird durch die von den lateral auslenkbaren Elemente 120 und 130 veranlasste laterale Verlagerung des zweiten Fingers 160-1 das Volumen der Teilkavität 116-1 abwechselnd verringert und vergrößert und umgekehrt das Volumen der benachbarten Teilkavität 116-2 abwechselnd vergrößert und verringert. Über die Öffnungen 170-1, ..., 170-5 bzw. 180-1, ..., 180-5 wirken die Änderung der Volumina der Teilkavitäten 116-1, ..., 116-10 auf das in der Umgebung des MEMS-Bauteils 100 vorhandene Umgebungsfluid und beeinflussen dieses dadurch. Entsprechend wirkt das MEMS-Bauteil 100 als Aktor.

Umgekehrt können sich die Mehrzahl an zweiten Fingern 160-1, ..., 160-5 gegenüber der Mehrzahl an ersten Fingern 150-1, ..., 150-6 auch lateral verschieben, um abhängig von dem Umgebungsfluid Volumina der benachbarten Teilkavitäten unter lateraler Verformung der zwei lateral auslenkbaren Elemente einzustellen. Beispielsweise kann abhängig von Druckverhältnissen bzw. Druckgradienten im Umgebungsfluid das Volumen der Teilkavität 116-1 verringert und das Volumen der benachbarten Teilkavität 116-2 vergrößert werden, so dass die Mehrzahl an zweiten Fingern 160-1, ..., 160-5 verschoben werden und aufgrund der äußeren Krafteinwirkung durch die Verschiebung der Mehrzahl an zweiten Fingern 160-1, ..., 160-5 die zwei lateral auslenkbaren Elemente 120 und 130 lateral verformt werden und entsprechend z.B. ein zweites Spannungssignal ausgeben. Das zweite Spannungssignal repräsentiert dabei die Druckverhältnisse bzw. Druckgradienten im Umgebungsfluid, so dass das MEMS-Bauteil 100 als Sensor wirkt.

Die zwischen der Mehrzahl an ersten Fingern 150-1, ..., 150-6 und der Mehrzahl an zweiten Fingern 160-1, ..., 160-5 gebildeten Teilkavitäten 116-1, ..., 116-10 bilden insgesamt eine große Fläche für die Interaktion mit dem Umgebungsfluid. Das MEMS-Bauteil kann dabei sowohl zur Beeinflussung des Umgebungsfluides, d.h. als Aktor, als auch zur Vermessung des Umgebungsfluides, d.h. als Sensor, genutzt werden. Im Vergleich zu den lateral auslenkbaren Elementen 120 und 130 weisen die Mehrzahl an ersten Fingern 150-1, ..., 150-6 und die Mehrzahl an zweiten Fingern 160-1, ..., 160-5 eine große Steifigkeit bei geringen geometrischen Anregungen auf, so dass die ersten und zweiten Finger selbst im Wesentlichen nicht zu Schwingungen angeregt werden und somit nicht die Interaktion mit dem Umgebungsfluid stören bzw. beeinflussen. Die zur Verfügung stehende Fläche des MEMS-Bauteils 100 kann aufgrund der Vielzahl an Teilkavitäten zu einem hohen Grad für die Interaktion mit dem Umgebungsfluid genutzt werden. Insbesondere bei einer Verwendung dünner erster und zweiter Finger können mehr und enger beieinanderliegende Teilkavitäten angeordnet werden. Wird das MEMS-Bauteil 100 beispielsweise zur Ausgabe eines Schallsignals (Schallfelds) in das Umgebungsfluid genutzt, kann so ein höherer Schalldruck erreicht werden. Wird das MEMS-Bauteil 100 beispielsweise zur Sensierung eines Schallsignals im Umgebungsfluid genutzt, kann eine höhere Sensitivität erreicht werden.

Zudem ermöglichen die kammartigen Anordnungen der ersten und zweiten Finger, dass nur ein vergleichsweise geringer (ungewollter) elektrischer Kapazitätsbelag erfolgt. Ebenso ermöglichen die kammartigen Anordnungen der ersten und zweiten Finger zusätzlich Einstellmöglichkeiten für die fluidische (Be-)Dämpfung.

Wie bereits bei der Beschreibung der einzelnen Elemente von MEMS-Bauteil 100 mehrfach angedeutet, können die einzelnen Elemente eines MEMS-Bauteils gemäß der vorgeschlagenen Architektur gegenüber dem in Fig. 1 dargestellten MEMS-Bauteil 100 auf vielfache Weise abgewandelt sein. Nachfolgend werden daher einige weitere MEMS-Bauteile gemäß der vorgeschlagenen Architektur näher beschrieben, wobei im Wesentlichen die Unterschiede zu dem oben ausführlich beschriebenen MEMS-Bauteil 100 hervorgehoben werden.

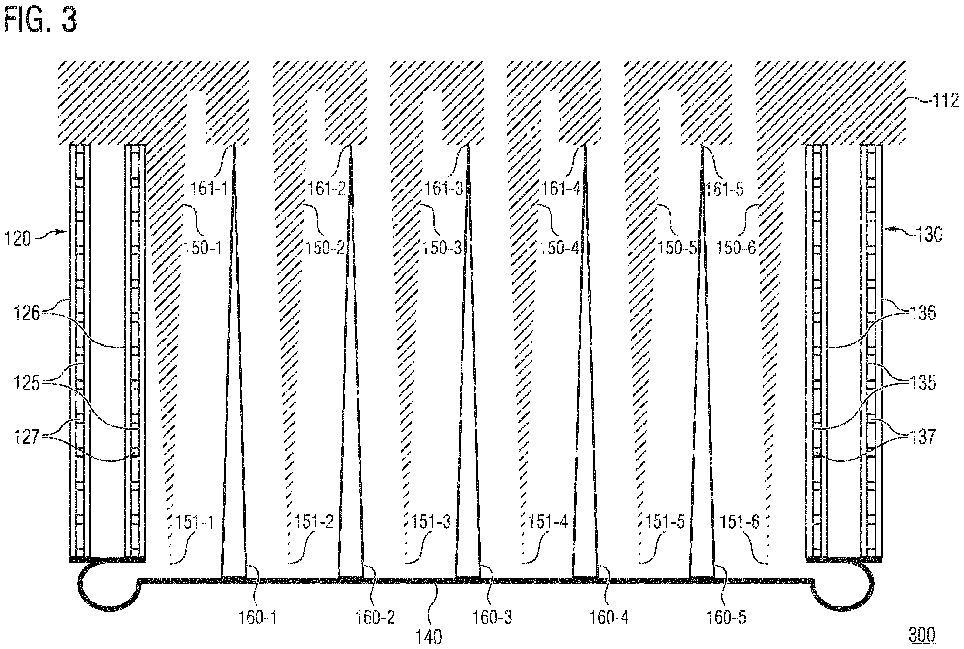

**Fig. 3** zeigt ein MEMS-Bauteil 300 mit im Vergleich zu MEMS-Bauteil 100 unterschiedlich ausgebildeten lateral auslenkbaren Elementen 120 und 130. Während die lateral auslenkbaren Elementen 120 und 130 des MEMS-Bauteils 100 jeweils aus zwei Teilelementen mit konkav gekrümmter Form gebildet sind, sind die die lateral auslenkbaren Elementen 120 und 130 des MEMS-Bauteils 300 balkenartig bzw. balkenförmig ausgebildet.

An beiden lateralen Seiten der lateral auslenkbaren Elemente 120 und 130 weisen diese jeweils eine erste Elektrodenschicht 125 bzw. 135 und eine zweite Elektrodenschicht 126 bzw. 136, zwischen denen eine unterbrochene, nicht-leitende Schicht 127 bzw. 137 ausgebildet ist, auf. Auch die Linearität der lateral auslenkbaren Elemente 120 und 130 des MEMS-Bauteils 300 ist sehr hoch und einstellbar.

Durch Anlegen ein eines ersten Spannungssignals an die erste Elektrodenschicht 125 bzw. 135 und die zweite Elektrodenschicht 126 bzw. 136 können die auslenkbaren Elementen 120 und 130 jeweils lateral verformt werden, um die lateral auslenkbaren Elementen 120 und 130 als Aktoren zur Beeinflussung des Umgebungsfluides zu betreiben.

Werden die auslenkbaren Elementen 120 und 130 aufgrund einer äußeren Krafteinwirkung durch das Umgebungsfluid lateral verformt, wird umgekehrt ein zweites Spannungssignal an der ersten Elektrodenschicht und der zweiten Elektrodenschicht erzeugt, so dass die lateral auslenkbaren Elementen 120 und 130 als Sensoren zur Sensierung des Umgebungsfluides dienen.

Die Mehrzahl an ersten Fingern 150-1, ..., 150-6 als auch die Mehrzahl an zweiten Fingern 160-1, ..., 160-5 laufen bei den in Figs. 1 bis 3 dargestellten Ausführungsbeispielen jeweils spitz zu. Ein Querschnitt jedes der Mehrzahl an ersten Fingern 150-1, ..., 150-6 nimmt somit von einem mit der Seitenwand 115 der Kavität 144 verbundenen Ende des jeweiligen ersten Fingers zum freien Enden 151-1, ..., 151-6 des jeweiligen ersten Fingers hin ab. Entsprechend nimmt ein Querschnitt jedes der Mehrzahl an zweiten Fingern 160-1, ..., 160-5 von einem mit dem Verbindungselement 140 verbundenen Ende des jeweiligen zweiten Fingers zu einem freien Enden 161-1, ..., 161-5 des jeweiligen zweiten Fingers hin ab.

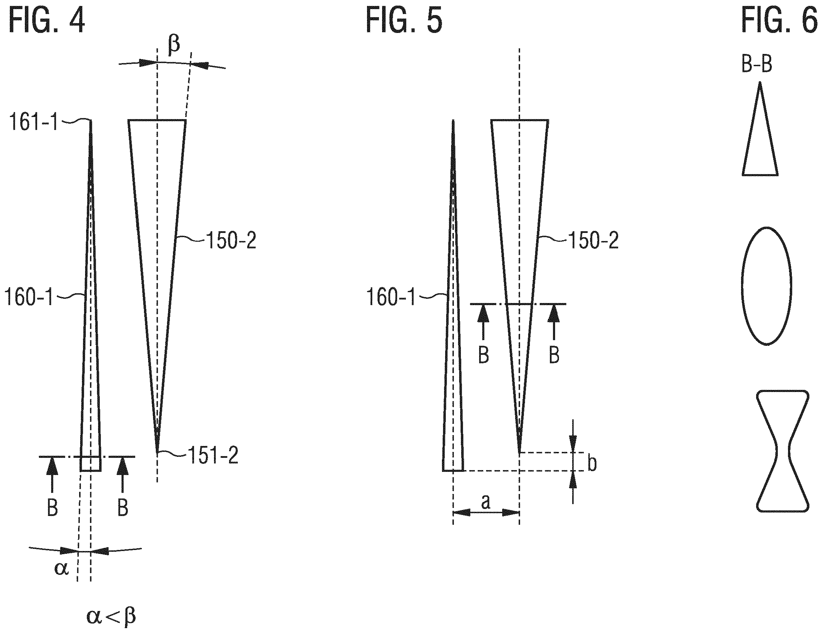

In **Fig. 4** sind der erste Finger 150-2 und der zweite Finger 160-1, welche zueinander benachbart sind, nochmals vergrößert dargestellt. An den in Fig. 4 beispielhaft gezeigten Fingern 150-2 und 160-1 sind die geometrischen Verhältnisse der Mehrzahl an ersten Fingern 150-1, ..., 150-6 und der Mehrzahl an zweiten Fingern 160-1, ..., 160-5 nochmals verdeutlicht.

Sowohl der erste Finger 150-2 und der zweite Finger 160-1 weisen jeweils eine keilförmige Grundform entlang ihrer Längserstreckung, d.h. einen sich verjüngenden Querschnitt, auf. Der zweite Finger 160-1 weist dabei einen Flankenwinkel α (Winkel zwischen Mittellinie und Seitenflanke des zweiten Fingers 150-2) auf, währen der erste Finger 150-2 einen Flankenwinkel β aufweist. Der jeweilige Flankenwinkel gibt dabei das Verhältnis der lateralen Erstreckung (d.h. die Erstreckung entlang der Seitenwand 115 der Kavität 114) zur Längserstreckung (d.h. von der Seitenwand 115 der Kavität 114 zum Verbindungselement 140 und umgekehrt) des jeweiligen Fingers an. Beispielsweise kann der Flankenwinkel α zwischen 0 und 30 °, insbesondere 10 ° oder 3 ° betragen. Der Flankenwinkel β kann z.B. zwischen 0 und 30 °, insbesondere 10 ° oder 3 ° betragen. Der Flankenwinkel β des ersten Fingers 150-2 ist dabei immer größer als der Flankenwinkel α des zweiten Fingers 160-1. Mit anderen Worten: Ein Verhältnis einer Lateralerstreckung eines Fingers der Mehrzahl an ersten Fingern 150-1, ..., 150-6 zu seiner Längserstreckung ist größer als ein Verhältnis einer Lateralerstreckung eines Fingers der Mehrzahl an zweiten Fingern 160-1, ..., 160-5 zu seiner Längserstreckung.

Aufgrund des größeren Flankenwinkels β ist das am Substrat angebrachte Ende des ersten Fingers 150-2 verhältnismäßig breiter als das entsprechend an dem Verbindungselement 140 angebrachte Ende des zweiten Fingers 160-1. Ferner ist der erste Finger 150-2 aufgrund des größeren Flankenwinkels β verhältnismäßig breiter als der zweite Finger 160-1.

Die Mehrzahl an ersten Fingern 150-1, ..., 150-6 sind somit massiver ausgestaltet als die Mehrzahl an zweiten Fingern 160-1, ..., 160-5, so dass diese schwerer zu Schwingungen aufgrund der sich ändernden Volumina der Teilkavitäten angeregt werden können. Entsprechend können die massiveren ersten Finger für eine effektive Entkopplung der Teilkavitäten sorgen.

Die keilförmigen Verläufe der Finger entlang ihrer Längserstreckungen haben zudem den Vorteil, dass die Mehrzahl an ersten Fingern 150-1, ..., 150-6 und die Mehrzahl an zweiten Fingern 160-1, ..., 160-5 in geringem Abstand voneinander angeordnet werden können. Der in **Fig. 5** angedeutete laterale Abstand a zwischen dem ersten Finger 150-2 und dem zweiten Finger 160-1 kann z.B. zwischen 0 und 100 µm, insbesondere 15 µm oder 10 µm betragen. Aufgrund der keilförmigen Verläufe der Finger kann der zweite Finger 160-1 in lateraler Richtung zudem weiter gegenüber dem ersten Finger 150-2 ausgelenkt werden als dies z.B. für balkenförmige Finger möglich ist. Entsprechend kann die Interaktion mit dem Umgebungsfluid verbessert sein.

In Fig. 5 ist mittels des Abstands b ferner angedeutet, dass das freie Ende 151-2 des ersten Fingers 150-2 nicht das Verbindungselement 140, an dem der zweite Finger 160-1 angeordnet ist, berührt. Vielmehr verbleibt der Abstand b zwischen dem freien Ende 151-2 des ersten Fingers 150-2 und dem Verbindungselement 140. Entsprechendes gilt für das freie Ende 161-1 des zweiten Fingers 160-1 in Bezug auf die Seitenwand 115 der Kavität 114, an welcher der ersten Finger 150-2 angeordnet ist.

Wie bereits oben mehrfach angedeutet kann der Querschnitt der Mehrzahl an ersten Fingern 150-1, ..., 150-6 als auch der Mehrzahl an zweiten Fingern 160-1, ..., 160-5 im Wesentlichen beliebig sein. **Fig. 6** zeigt eine Schnittansicht entlang der Schnittlinie B-B in Fig. 5, um verschiedene mögliche Querschnitte für die ersten und zweiten Finger anzudeuten. Beispielsweise können die Finger einen keilförmigen Querschnitt, einen ovalen Querschnitt oder einen konkaven Querschnitt, wie dies in Fig. 6 dargestellt ist, aufweisen. In einigen Ausführungsbeispielen können die ersten und/oder die zweiten Finger auch einen balkenförmigen (d.h. rechtwinkligen, z.B. quadratischen) Querschnitt aufweisen. Gemäß Ausführungsbeispielen können einzelne Finger der Mehrzahl an ersten Fingern 150-1, ..., 150-6 als auch der Mehrzahl an zweiten Fingern 160-1, ..., 160-5 unterschiedliche Querschnitte und/oder Kombinationen der oben genannten Querschnittsformen aufweisen.

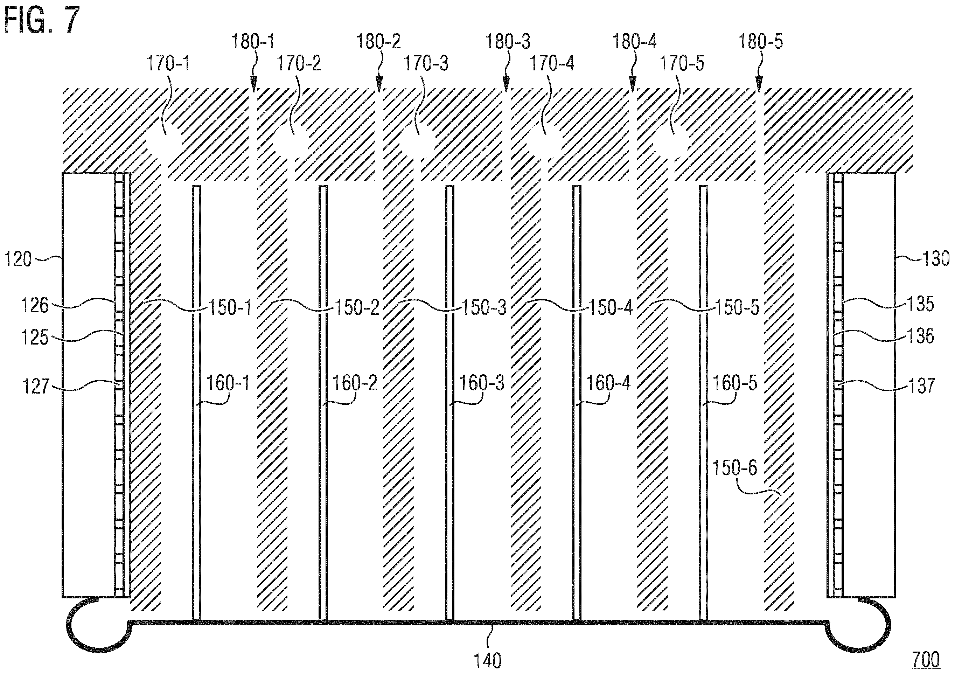

**Fig. 7** zeigt ein weiteres MEMS-Bauteil 700, mit im Vergleich zu den MEMS-Bauteilen 100 und 300 unterschiedlich ausgebildeten lateral auslenkbaren Elementen 120 und 130. Im Gegensatz zu den lateral auslenkbaren Elementen 120 und 130 des MEMS-Bauteils 300, ist bei den lateral auslenkbaren Elementen 120 und 130 des MEMS-Bauteils 700 jeweils nur an einer lateralen Seiten der lateral auslenkbaren Elemente 120 und 130 die erste Elektrodenschicht 125 bzw. 135 und die zweite Elektrodenschicht 126 bzw. 136, zwischen denen die unterbrochene, nicht-leitende Schicht 127 bzw. 137 ausgebildet ist, angeordnet. Die Querschnitte der beiden Elektrodenschichten 125 bzw. 135 und 126 bzw. 136 unterscheiden sich dabei, um die laterale Verformung bei Anlegen eines Potentials zu ermöglichen.

Ferner sind die Mehrzahl an ersten Fingern 150-1, ..., 150-6 als auch die Mehrzahl an zweiten Fingern 160-1, ..., 160-5 in MEMS-Bauteil 700 anders als in den MEMS-Bauteilen 100 und 300 ausgebildet. Anders als die Mehrzahl an ersten Fingern 150-1, ..., 150-6 als auch die Mehrzahl an zweiten Fingern 160-1, ..., 160-5 in den MEMS-Bauteilen 100 und 300 laufen die Mehrzahl an ersten Fingern 150-1, ..., 150-6 als auch die Mehrzahl an zweiten Fingern 160-1, ..., 160-5 in dem MEMS-Bauteil 700 nicht spitz zu. Der Querschnitt jedes der Mehrzahl an ersten Fingern 150-1, ..., 150-6 und jedes der Mehrzahl an zweiten Fingern 160-1, ..., 160-5 bleibt von seinem mit der Seitenwand 115 der Kavität 144 bzw. seinem mit dem Verbindungselement 140 verbundenen Ende zum freien Enden des jeweiligen Fingers hin im Wesentlichen konstant.

Ferner ist in Fig. 7 angedeutet, dass auch die Form der Öffnungen der einzelnen Teilkavitäten variable bzw. im Wesentlichen beliebig sein kann. Während die Öffnungen 170-1, ..., 170-5 in den Figs. 1 und 3 als im Wesentlichen rechteckig dargestellt sind, sind die Öffnungen 170-1, ..., 170-5 im Wesentlichen kreisförmig. Dabei ist zu beachten, dass die in den Figs. 1, 3 und 7 gezeigten Formen für die Öffnungen 170-1, ..., 170-5 rein beispielhaft zur Darstellung der vorgeschlagenen Architektur gewählt sind. Die Öffnungen 170-1, ..., 170-5 können jede beliebige andere Form aufweisen (z.B. oval, n-eckig, freie Form, etc.). Entsprechendes gilt auch für die Öffnungen 180-1, ..., 180-6.

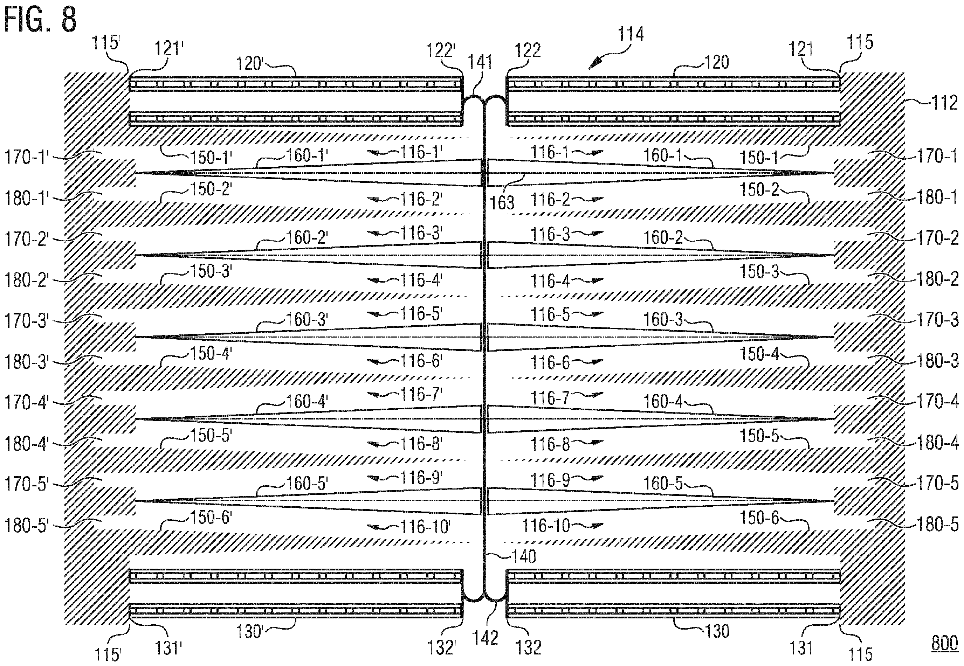

**Fig. 8** zeigt ferner eine Draufsicht auf ein weiteres MEMS-Bauteil 800 mit auf beiden Seiten des Verbindungselements 140 angeordneten kammartigen Strukturen. Wie aus Fig. 8 ersichtlich ist, ist das oben in Zusammenhang mit Fig. 3 beschriebene MEMS-Bauteil 300 dabei im Wesentlich an dem Verbindungselement 140 gespiegelt, um die zweite kammartige Struktur zu erhalten.

Das MEMS-Bauteil 800 umfasst zusätzlich zu den bereits oben in Zusammenhang mit MEMS-Bauteil 300 beschriebenen Elementen die nachfolgend beschriebenen Elemente.

Das MEMS-Bauteil 800 ferner zwei weitere lateral auslenkbare Elemente 120' und 130', die lateral zueinander beabstandet in der Kavität 114 angeordnet sind. Jedes der zwei weiteren lateral auslenkbaren Elemente 120' und 130' weist jeweils ein mit einer weiteren Seitenwand 115' der Kavität 114 verbundenes Ende auf 121' bzw. 131' auf. Das Verbindungselement 140 ist über entsprechend angepasste flexible Element 141 mit den freien Enden 122` bzw. 132` der zwei weiteren lateral auslenkbaren Elementen 120' und 130' verbunden. Die zwei weiteren lateral auslenkbaren Elementen 120' und 130' können dabei wie die lateral auslenkbaren Elementen 120 und 130 ausgebildet sein.

Ferner sind eine Mehrzahl an dritten Fingern 150-1', ..., 150-6' diskret zueinander beabstandet zwischen den zwei weiteren lateral auslenkbaren Elementen 120' und 130' an der weiteren Seitenwand 115` der Kavität 114 angeordnet.

Eine Mehrzahl an vierten Fingern 160-1', ..., 160-5' sind diskret zueinander beabstandet zwischen den zwei weiteren lateral auslenkbaren Elementen 120' und 130` an dem Verbindungselement 140 angeordnet sind. Die Mehrzahl an zweiten Fingern 160-1, ..., 160-5 und die Mehrzahl an vierten Fingern 160-1', ..., 160-5' sind auf gegenüberliegenden Seiten des Verbindungselements 140 angeordnet. Die Mehrzahl an vierten Fingern 160-1', ..., 160-5' greifen mit der Mehrzahl an dritten Fingern 150-1', ..., 150-6' in der gleichen Weise ineinander wie dies die Mehrzahl an zweiten Fingern 160-1, ..., 160-5 mit der Mehrzahl an ersten Fingern 150-1, ..., 150-6 tun. Entsprechend begrenzen die Mehrzahl an dritten Fingern 150-1', ..., 150-6' und die Mehrzahl an vierten Fingern 160-1`, ..., 160-5' eine weitere Mehrzahl an volumenveränderlichen Teilkavitäten 116-1', ..., 116-10` innerhalb der Kavität 114.

Jede der weiteren Mehrzahl an Teilkavitäten 116-1', ..., 116-10' steht analog zu den Teilkavitäten 116-1, ..., 116-10 über eine jeweilige Öffnung 170-1', ..., 170-5' bzw. 180-1', ..., 180-5' mit dem Umgebungsfluid in Kontakt. Die Öffnungen 170-1', ..., 170-5' bzw. 180-1', ..., 180-5' sind dabei analog zu den Öffnungen 170-1, ..., 170-5 bzw. 180-1, ..., 180-5 gebildet. Bei benachbarten Teilkavitäten der weitere Mehrzahl an Teilkavitäten 116-1', ..., 116-10' ist somit jeweils die Öffnung der einen Teilkavität der benachbarten Teilkavitäten in einer anderen Schicht der ersten Schicht 111, der zweiten Schicht 112 und der dritten Schicht 113 als die Öffnung der anderen Teilkavität der benachbarten Teilkavitäten gebildet. Über eine entsprechende Aussparung in der Seitenwand 115 bzw. der weiteren Seitenwand 115' der Kavität 114 sind abwechselnd entweder in der ersten Schicht 111 (z.B. in Form eines Handlingwafers) oder der dritten Schicht 113 (z.B. in Form eines Deckelwafers) ausgebildeten Öffnungen 170-1', ..., 170-5' bzw. 180-1', ..., 180-5' mit den Teilkavitäten 116-1', ..., 116-10' verbunden. Aufgrund der Draufsicht sind die ersten Schicht 111 und die dritten Schicht 113 in Fig. 8 nicht dargestellt.

Die lateral auslenkbaren Elemente 120, 120', 130 und 130' bewegen sich gleichsinnig in MEMS-Bauteil 800.

Jeweils gegenüberliegende Finger der Mehrzahl an zweiten Fingern 160-1, ..., 160-5 und der Mehrzahl an vierten Fingern 160-1', ..., 160-5' weisen eine gemeinsame Symmetrieachse 163 auf, d.h. sie sind spiegelverkehrt bzgl. des Verbindungselements 140. Mit diesem Aufbau können vorteilhafterweise fluidwiderstandsinduzierte Momente, die aus der Bewegung der Mehrzahl an zweiten Fingern 160-1, ..., 160-5 und der Mehrzahl an vierten Fingern 160-1', ..., 160-5' gegenüber dem Umgebungsfluid resultieren, ausgeglichen werden. So können Spannungen im Werkstoff im Bereich der Einspannung bzw. Befestigung der Mehrzahl an zweiten Fingern 160-1, ..., 160-5 und der Mehrzahl an vierten Fingern 160-1', ..., 160-5' an dem Verbindungselement 140 (erheblich) reduziert werden. Deshalb können sehr dünne Finger (d.h. Finger mit geringer lateraler Erstreckung) für die Mehrzahl an zweiten Fingern 160-1, ..., 160-5 und die Mehrzahl an vierten Fingern 160-1', ..., 160-5' verwendet werden.

Mit dem in Fig. 8 dargestellten Aufbau lässt sich eine erhöhte Packungsdichte der aktiven (lateral auslenkbare Elemente) und der passiven (sonstige Elemente) Elemente in dem Gesamtaufbau realisieren.

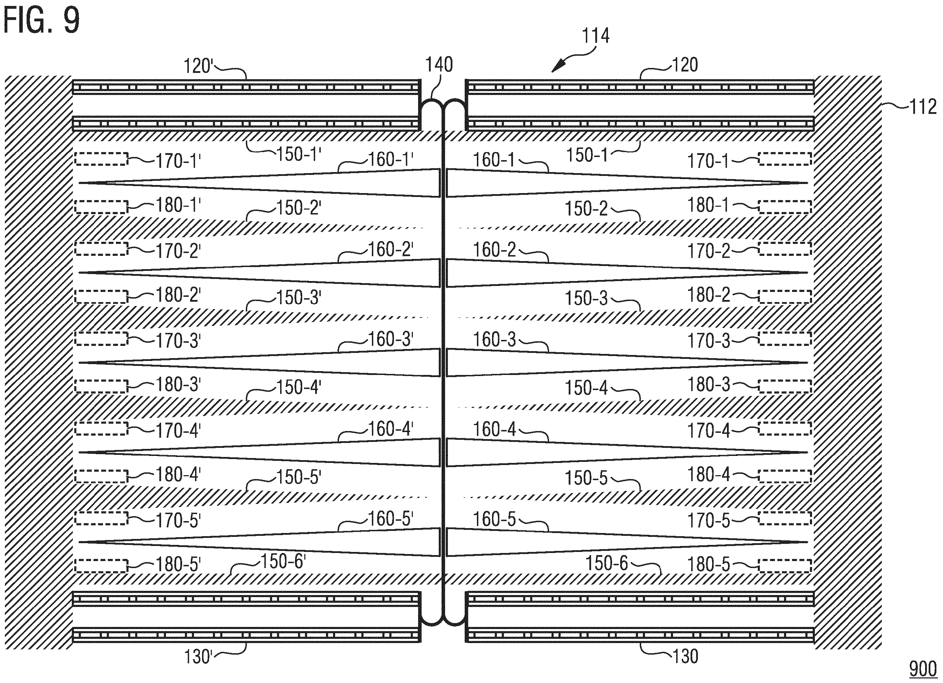

**Fig. 9** zeigt ein weiteres MEMS-Bauteil 900, bei dem die Anbindung der Öffnungen 170-1, ..., 170-5 bzw. 180-1, ..., 180-5 und 170-1', ..., 170-5' bzw. 180-1`, ..., 180-5' an die Teilkavitäten 116-1, ..., 116-10 und 116-1', ..., 116-10' im Vergleich zu MEMS-Bauteil 800 modifiziert ist. Die Öffnungen 170-1, ..., 170-5 bzw. 180-1, ..., 180-5 und 170-1', ..., 170-5' bzw. 180-1', ..., 180-5' sind bei MEMS-Bauteil 900 im Vergleich zu MEMS-Bauteil 800 ausschließlich in der ersten Schicht 111 und der dritten Schicht 113 gebildet. Es sind keine Aussparungen in der Seitenwand 115 bzw. der weiteren Seitenwand 115' der Kavität 114 nötig, um die Öffnungen 170-1, ..., 170-5 bzw. 180-1, ..., 180-5 und 170-1`, ..., 170-5' bzw. 180-1', ..., 180-5' an die Teilkavitäten 116-1, ..., 116-10 und 116-1', ..., 116-10' anzubinden. Die Positionen der Öffnungen 170-1, ..., 170-5 bzw. 180-1, ..., 180-5 und 170-1', ..., 170-5' bzw. 180-1', ..., 180-5' in der ersten Schicht 111 bzw. der dritten Schicht 113 sind in Fig. 9 gestrichelt dargestellt.

Ebenso ist MEMS-Bauteil 900 gegenüber MEMS-Bauteil 800 dahingehend modifiziert, dass jeweils der erste Finger und der letzte Finger der Mehrzahl an ersten Fingern 150-1, ..., 150-6 als auch der Mehrzahl an dritten Fingern 150-1', ..., 150-6' (d.h. die zu den lateral auslenkbaren Elementen 120, 120', 130 und 130' unmittelbar benachbarten ersten und dritten Finger) jeweils keinen zum freien Ende des jeweiligen Fingers hin spitz zulaufenden Querschnitt, sondern einen im Wesentlichen konstanten Querschnitt (d.h. eine gleichmäßige bzw. konstante Breite) aufweist. Aus Fig. 9 ist somit ersichtlich, dass unterschiedliche Finger unterschiedliche Formen aufweisen können.

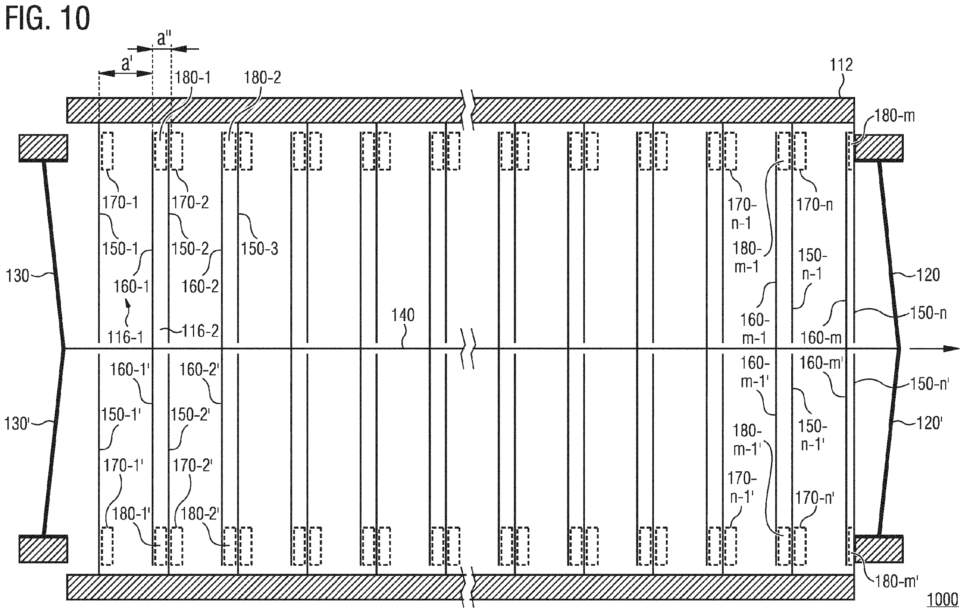

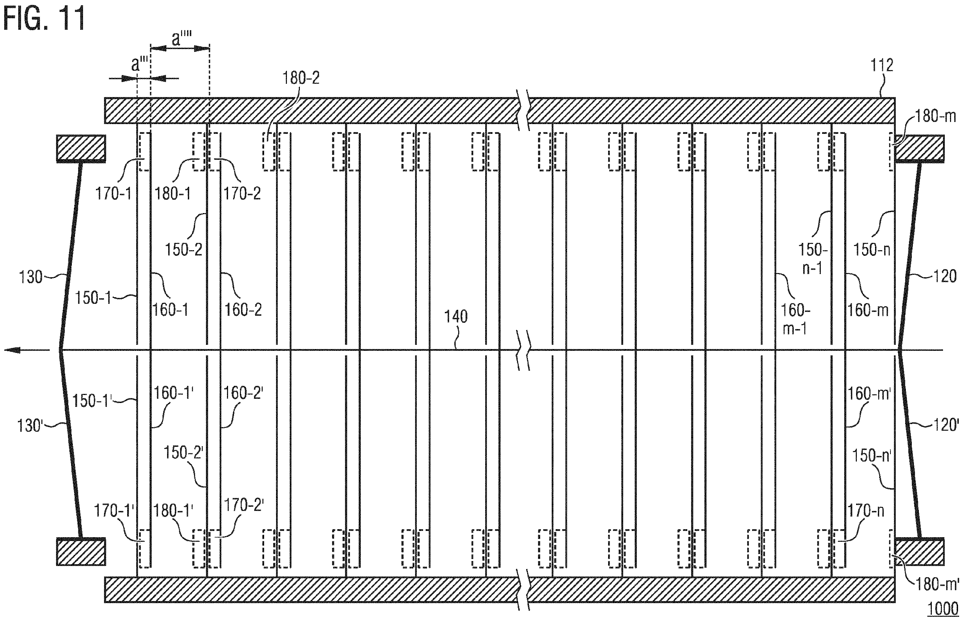

Die Figs. 10 und 11 zeigen schematisch ein weiteres MEMS-Bauteil 1000 während lateraler Auslenkungen in entgegengesetzte Richtung. Wie aus **Fig. 10** ersichtlich ist, weist das MEMS-Bauteil 1000 wie die MEMS-Bauteile 800 und 900 zwei kammartige Strukturen auf.

An dem über die lateral auslenkbaren Elemente 120, 120', 130 und 130' in lateraler Richtung bewegbaren Verbindungselement 140 sind somit an gegenüber liegenden Seiten die zweite Mehrzahl an Fingern 160-1, ..., 160-m, die mit der ersten Mehrzahl an Fingern 150-1, ..., 150-n ineinandergreifen, und die vierte Mehrzahl an Fingern 160-1', ..., 160-m', die mit der dritten Mehrzahl an Fingern 150-1', ..., 150-n' ineinandergreifen, angeordnet.

In der in Fig. 10 dargestellten Situation sind die lateral auslenkbaren Elemente nach rechts gebogen, d.h. in einer erste Richtung lateral verformt, so dass während eines ersten Zeitintervalls bei benachbarten Teilkavitäten ein Volumen der einen Teilkavität der benachbarten Teilkavitäten vergrößert ist und ein Volumen der anderen Teilkavität der benachbarten Teilkavitäten verringert ist. Dies ist in Fig. 10 exemplarisch für die Teilkavitäten 116-1 und 116-2 angedeutet.

Aufgrund der lateralen Auslenkung/Verschiebung der zweiten Mehrzahl an Fingern 160-1, ..., 160-m durch die lateral auslenkbaren Elemente 120, 120', 130 und 130', vergrößert sich der laterale Abstand zwischen dem ersten Finger 150-1 und dem zweiten Finger 160-1 vom Wert a im unausgelenkten Zustand (siehe Fig. 5) auf den Wert a`, so dass sich das Volumen der Teilkavität 116-1 vergrößert. Umgekehrt, verringert sich der laterale Abstand zwischen dem zweiten Finger 160-1 und dem ersten Finger 150-2 vom Wert a im unausgelenkten Zustand (siehe Fig. 5) auf den Wert a", so dass sich das Volumen der Teilkavität 116-2 verringert. Für die weiteren Teilkavitäten gilt dies entsprechend.

Aufgrund der Vergrößerung des Volumens der Teilkavität 116-1 erfolgt ein Volumenstrom des Umgebungsfluides durch die Öffnung 170-1 (im Deckelwafer) in die Teilkavität 116-1. Umgekehrt erfolgt aufgrund der Verkleinerung des Volumens der Teilkavität 116-2 ein Volumenstrom des Fluides durch die Öffnung 180-1 (im Bodenwafer) aus der Teilkavität 116-2 heraus, um das Fluid aus der Teilkavität 116-2 herauszubefördern. Für die weiteren Teilkavitäten gilt dies entsprechend, so dass Fluid durch die Öffnungen 170-1, ..., 170-n und 170-1', ..., 170-n' in einen ersten Anteil aller Teilkavitäten aus der Umgebung des MEMS-Bauteils 1000 strömt und umgekehrt Fluid durch die Öffnungen 180-1, ..., 180-m und 180-1', ..., 180-m' aus einem zweiten Anteil aller Teilkavitäten in die Umgebung des MEMS-Bauteils 1000 strömt.

In der in **Fig. 11** dargestellten Situation sind die lateral auslenkbaren Elemente nunmehr nach links gebogen, d.h. in einer umgekehrten zweiten Richtung lateral verformt, so dass während eines zweiten Zeitintervalls nunmehr umgekehrt das Volumen der einen Teilkavität der benachbarten Teilkavitäten vergrößert ist und das Volumen der anderen Teilkavität der benachbarten Teilkavitäten verringert ist. Dies ist in Fig. 11 wiederum exemplarisch für die Teilkavitäten 116-1 und 116-2 angedeutet.

Aufgrund der lateralen Auslenkung/Verschiebung der zweiten Mehrzahl an Fingern 160-1, ..., 160-m in die entgegengesetzte Richtung durch die lateral auslenkbaren Elemente 120, 120', 130 und 130', verringert sich der laterale Abstand zwischen dem ersten Finger 150-1 und dem zweiten Finger 160-1 vom Wert a im unausgelenkten Zustand (siehe Fig. 5) auf den Wert a" `, so dass sich das Volumen der Teilkavität 116-1 verringert. Umgekehrt, vergrößert sich der laterale Abstand zwischen dem zweiten Finger 160-1 und dem ersten Finger 150-2 vom Wert a im unausgelenkten Zustand (siehe Fig. 5) auf den Wert a‴′, so dass sich das Volumen der Teilkavität 116-2 vergrößert. Für die weiteren Teilkavitäten gilt dies entsprechend.

Aufgrund der Vergrößerung des Volumens der Teilkavität 116-2 erfolgt ein Volumenstrom des Umgebungsfluides durch die Öffnung 180-1 in die Teilkavität 116-2. Umgekehrt erfolgt aufgrund der Verkleinerung des Volumens der Teilkavität 116-1 ein Volumenstrom des Fluides durch die Öffnung 170-1 aus der Teilkavität 116-1 heraus, um das Fluid aus der Teilkavität 116-1 herauszubefördern. Für die weiteren Teilkavitäten gilt dies entsprechend, so dass Fluid durch die Öffnungen 180-1, ..., 180-m und 180-1', ..., 180-m` in den zweiten Anteil aller Teilkavitäten aus der Umgebung des MEMS-Bauteils 1000 strömt und umgekehrt Fluid durch die Öffnungen 170-1, ..., 170-n und 170-1', ..., 170-n' aus dem ersten Anteil aller Teilkavitäten in die Umgebung des MEMS-Bauteils 1000 strömt.

Die Fluidströme in die / aus den einzelnen Teilkavitäten sind während des in Fig. 11 dargestellten zweiten Zeitintervalls somit umgekehrt zu den Fluidströmen in die / aus den einzelnen Teilkavitäten während des in Fig. 10 dargestellten ersten Zeitintervalls.

Durch eine entsprechende Ansteuerung der lateral auslenkbaren Elemente 120, 120', 130 und 130' (z.B. über ein elektrisches, magnetisches oder thermisches Potential) kann mittels der induzierten Bewegung der zweiten Mehrzahl an Fingern 160-1, ..., 160-m und der vierten Mehrzahl an Fingern 160-1', ..., 160-m` das Umgebungsfluid in der Umgebung des MEMS-Bauteils somit beeinflusst werden (z.B. zu Schwingungen angeregt werden).

Wenn die lateral auslenkbaren Elemente 120, 120', 130 und 130' des MEMS-Bauteils 1000 nicht aktiv angesteuert werden, sondern als Sensoren zur Sensierung der Druckverhältnisse bzw. Druckgradienten des Umgebungsfluides genutzt werden, können die in Figs. 10 und 11 dargestellten Auslenkungen umgekehrt sich auch aus den Druckverhältnissen bzw. Druckgradienten des Umgebungsfluides ergeben. Beispielsweise kann eine Druckänderung im Umgebungsfluid die in Figs. 10 und 11 dargestellten Änderungen der Volumina der einzelnen Teilkavitäten bewirken, so dass die laterale Verformung der lateral auslenkbaren Elemente 120, 120', 130 und 130' ansprechend auf die Druckänderung im Umgebungsfluid, das das MEMS-Bauteil 1000 umgibt, erfolgt. Die lateral auslenkbaren Elemente 120, 120', 130 und 130' geben dann aufgrund ihrer lateralen Verformung ein entsprechendes (z.B. elektrisches, magnetisches oder thermisches) Potential aus, dass die Druckänderung im Umgebungsfluid beschreibt.

Es versteht sich von selbst, dass die obigen Ausführungen zu den Figs. 10 und 11 in analoger Weise auch für die weiteren Ausführungsbeispiele der vorliegenden Offenbarung zutreffen.

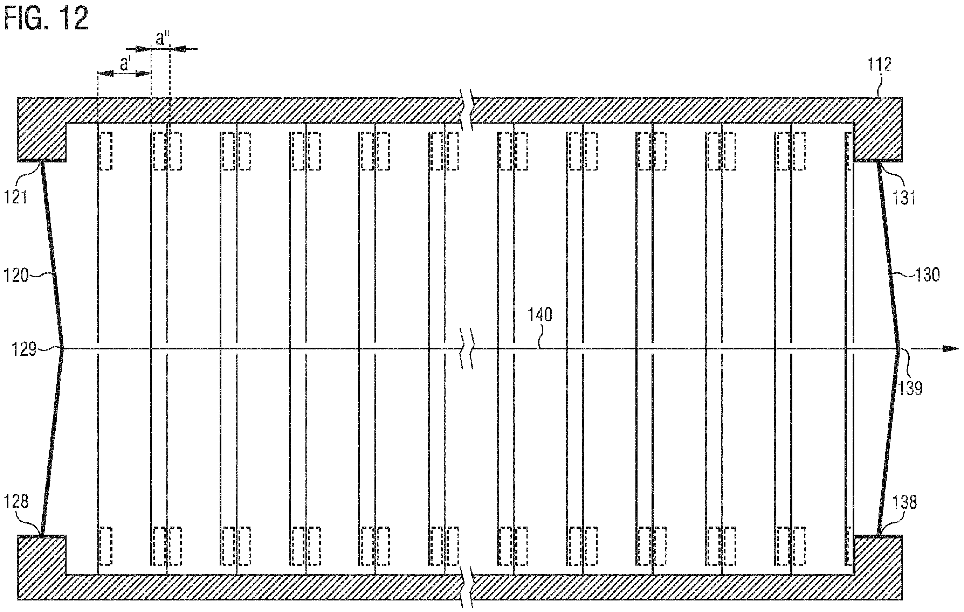

Bei den bisher beschriebenen MEMS-Bauteilen gemäß der vorliegenden Architektur wies jedes der lateral auslenkbaren Elemente jeweils ein am Substrat der zweiten Schicht angebrachtes Ende (d.h. ein eingespanntes Ende) sowie ein freies Ende, an dem das Verbindungselemente 140 angebracht ist, auf. Eine derartige Einspannung der lateral auslenkbaren Elemente ist jedoch nur eine mögliche Option. **Fig. 12** zeigt ein alternatives MEMS-Bauteil 1200, bei dem die lateral auslenkbaren Elemente beidseitig eingespannt sind, d.h. kein freies bzw. frei bewegliches Ende aufweisen.

Das MEMS-Bauteil 1200 ist bis auf die Einspannung der lateral auslenkbaren Elemente identisch zu MEMS-Bauteil 1000, so dass im Folgenden lediglich auf diesen Unterschied eingegangen wird.

Das MEMS-Bauteil 1200 umfasst zwei lateral auslenkbare Elemente 120 und 130, die wie auch in den vorangehenden Ausführungsbeispielen ein mit der Seitenwand 115 der Kavität 114 verbundenes Ende 121 bzw. 131 aufweisen. Ferner weisen die zwei lateral auslenkbaren Elemente 120 und 130 jeweils ein mit der weiteren Seitenwand 115' der Kavität 114 verbundenes weiteres Ende 128 bzw. 138 auf. Die Seitenwand 115 und die weitere Seitenwand 115' liegen einander gegenüber, so dass die zwei lateral auslenkbaren Elemente 120 und 130 nunmehr an ihren beiden Enden eingespannt sind. Da die Enden 121 bzw. 131 und 128 bzw. 138 der zwei lateral auslenkbaren Elemente 120 und 130 in dem in Figs. 12 dargestellten Ausführungsbeispiel nicht bewegbar sind, erfolgt die Verformung der zwei lateral auslenkbaren Elemente 120 und 130 in einem jeweiligen Mittenbereich 129 bzw. 139 entlang ihrer Längserstreckung. Dies ist in Fig. 12 beispielhaft für eine laterale Auslenkung nach rechts, analog zu der in Fig. 10 dargestellten Situation, dargestellt. Das Verbindungselement 140 ist daher entsprechend an den jeweiligen Mittenbereich 129 bzw. 139 der zwei lateral auslenkbaren Elemente 120 und 130 gekoppelt. Analog zu den Ausführungen zu MEMS-Bauteil 1000 können die zweiten und die vierten Finger lateral durch die beidseitig eingespannten, lateral auslenkbaren Elemente 120 und 130 gegenüber den ersten bzw. dritten Fingern lateral ausgelenkt werden.

Während die vorangehenden Abschnitte sich auf die Details von MEMS-Bauteilen gemäß der vorgeschlagenen Architektur konzentriert haben, soll im Folgenden näher auf die Anwendung der MEMS-Bauteile eingegangen werden.

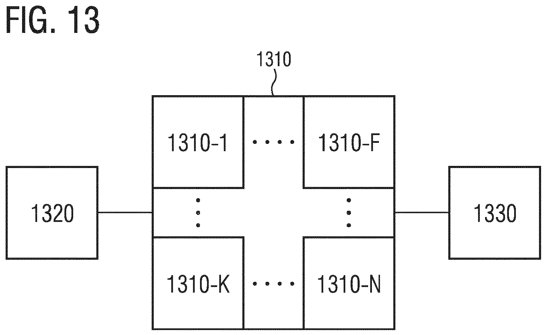

Dazu ist in **Fig. 13** eine Baugruppe 1300 dargestellt. Die Baugruppe 1300 umfasst eine Mehrzahl an MEMS-Bauteilen 1310 gemäß der vorgeschlagenen Architektur bzw. einem der hierein beschriebenen Ausführungsbeispiele. Die Anordnung der MEMS-Bauteile zueinander ist durch die Darstellung der einzelnen MEMS-Bauteile 1310-1, 1310-F, 1310-K und 1310-N angedeutet. Die Mehrzahl an MEMS-Bauteilen 1310 können im Wesentlichen beliebig zueinander ausgerichtet sein. Beispielsweise können die Mehrzahl an MEMS-Bauteilen 1310 auf einem gemeinsamen Halbleiterchip oder einem Halbleiter-Die ausgebildet sein.

Abhängig von der Art der Baugruppe 1300 kann die Baugruppe eine Steuerschaltung 1320 und/oder eine Messschaltung 1330 aufweisen.

Die Steuerschaltung 1320 ist eingerichtet, zumindest ein erstes Potential (z.B. ein erstes Spannungssignal, ein erstes magnetisches Potential oder ein erstes thermisches Potential) für die lateral auslenkbaren Elemente zumindest eines Teils der Mehrzahl an MEMS-Bauteilen 1310 bereitzustellen, um die jeweiligen lateral auslenkbaren Elemente als Aktoren zur Beeinflussung des Umgebungsfluid zu betreiben.

Die Messschaltung 1330 ist eingerichtet, zweite Potentiale (z.B. ein zweites Spannungssignal, ein zweites magnetisches Potential oder ein zweites thermisches Potential) der jeweiligen lateral auslenkbaren Elemente zumindest eines Teils der Mehrzahl an MEMS-Bauteilen 1310 zu messen, um die jeweiligen lateral auslenkbaren Elemente als Sensoren für das Umgebungsfluid zu betreiben.

Sollen die Mehrzahl an MEMS-Bauteilen 1310 als Aktoren betrieben werden, weist die Baugruppe 1300 die Steuerschaltung 1320 auf. Beispielsweise kann die Baugruppe 1300 ein Kopfhörer, ein Lautsprecher oder dergleichen sein, so dass über die Mehrzahl an MEMS-Bauteilen 1310 eine Beeinflussung des die MEMS-Bauteile 1310 umgebenden Umgebungsfluides zur Ausgabe eines Schallsignals erfolgt. Gemäß weiteren Ausführungsbeispielen kann die Baugruppe 1300 auch eine Fluidpumpe sein, so dass über die Mehrzahl an MEMS-Bauteilen 1310 eine Beeinflussung des die MEMS-Bauteile 1310 umgebenden Umgebungsfluides zum Fluidtransport erfolgt.

Sollen die Mehrzahl an MEMS-Bauteilen 1310 als Sensoren betrieben werden, weist die Baugruppe 1300 die Messschaltung 1330 auf. Beispielsweise kann die Baugruppe 1300 ein Mikrofon sein, dass über die Mehrzahl an MEMS-Bauteilen 1310 eine Sensierung des die MEMS-Bauteile 1310 umgebenden Umgebungsfluides ermöglicht.

Gemäß Ausführungsbeispielen kann ein erster Teil der Mehrzahl an MEMS-Bauteilen 1310 auch als Aktoren und ein zweiter Teil der Mehrzahl an MEMS-Bauteilen 1310 als Sensoren betrieben werden. Beispielsweise kann die Baugruppe 1300 in dieser Ausführungsform ein Kopfhörer mit aktiver Geräuschunterdrückung (engl. noise cancelling) sein.

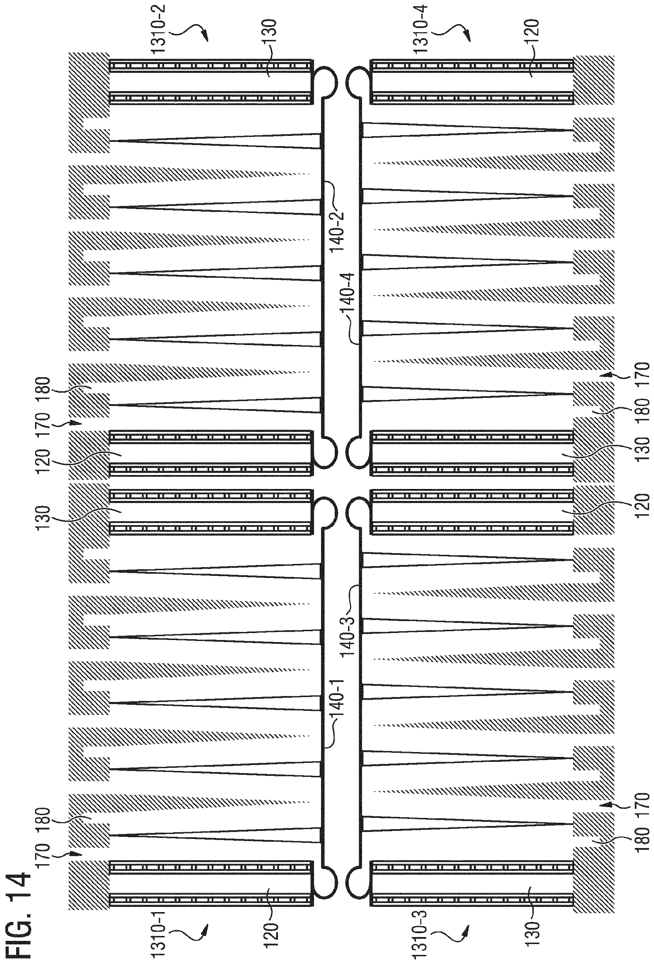

Wie bereits oben ausgeführt, kann die Anordnung der Mehrzahl an MEMS-Bauteilen 1310 relativ zueinander im Wesentlichen beliebig sein. Nachfolgend werden unter Bezugnahme auf die Figs. 14 bis 17 zur Illustration einige mögliche Anordnungen der MEMS-Bauteile innerhalb der Baugruppe vorgestellt. In den Figs. 14 bis 17 sind zur besseren Verständlichkeit jeweils vier MEMS-Bauteile 1310-1, ... , 1310-4 gezeigt. Es versteht sich von selbst, dass die in Zusammenhang mit Figs. 14 bis 17 gemachten Ausführungen nicht auf Baugruppen mit exakt vier MEMS-Bauteilen beschränkt sind, sondern für jedwede Anzahl an MEMS-Bauteilen gelten.

In Fig. 14 sind die MEMS-Bauteile 1310-1, ... , 1310-4 in zwei Reihen angeordnet, so dass die MEMS-Bauteile 1310-1 und 1310-2 in einer ersten Reihe und die MEMS-Bauteile 1310-3 und 1310-4 in einer zweiten Reihe angeordnet sind. Die MEMS-Bauteile 1310-3 und 1310-4 sind dabei gegenüberliegend zu den MEMS-Bauteile 1310-1 und 1310-2 angeordnet, so dass die jeweiligen Verbindungselemente 140-3 und 140-4 der MEMS-Bauteile 1310-3 und 1310-4 den jeweiligen Verbindungselementen 140-1 und 140-2 der MEMS-Bauteile 1310-1 und 1310-2 gegenüberliegen und zueinander beabstandet sind. Die MEMS-Bauteile 1310-3 und 1310-4 sind somit gegenüber den MEMS-Bauteilen 1310-1 und 1310-2 um 180 ° gedreht.

Der Abstand der MEMS-Bauteile 1310-3 und 1310-4 zu den MEMS-Bauteilen 1310-1 und 1310-2 kann z.B. zwischen 1 und 200 µm, insbesondere 80 oder 20 µm betragen.

Die Öffnungen 170 für einen Teil der Teilkavitäten sind im Substrat der zweiten Schicht gebildet, während die Öffnungen der jeweils benachbarten Teilkavitäten in der dritten Schicht gebildet sind. Dabei ist zu beachten, dass diese Konfiguration der Öffnungen 170 und 180 rein beispielhaft gewählt ist und auch andere Konfigurationen möglich sind (z.B. Öffnungen 170 oder Öffnungen 180 in der ersten Schicht).

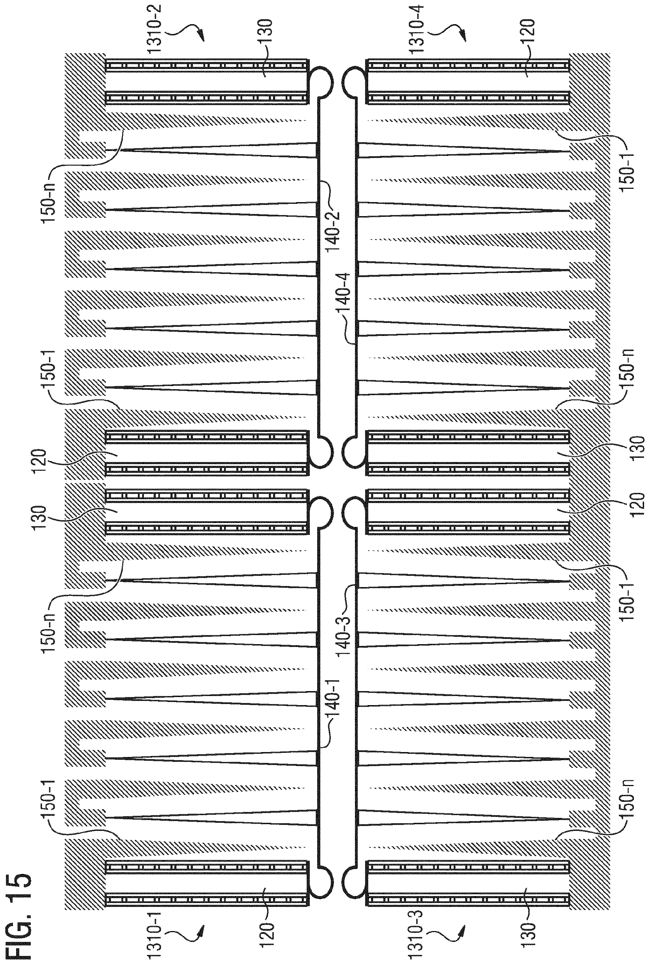

Ebenso ist zu beachten, dass die Anzahl an ersten und zweiten Fingern in Fig. 14 rein beispielhaft gewählt ist und auch mehr oder weniger Finger verwendet werden können. Um dies zu verdeutlichen weisen die MEMS-Bauteile 1310-1, ... , 1310-4 in **Fig. 15** jeweils zusätzliche erste Finger 150-1 und 150-n benachbart zu den lateral auslenkbaren Elementen 120 und 130 auf. Im Gegensatz zu dem in Fig. 15 gezeigten Ausführungsbeispiel nehmen die in Fig. 14 gezeigten lateral auslenkbaren Elementen 120 und 130 aktiv an der Wechselwirkung mit dem Umgebungsfluid teil.

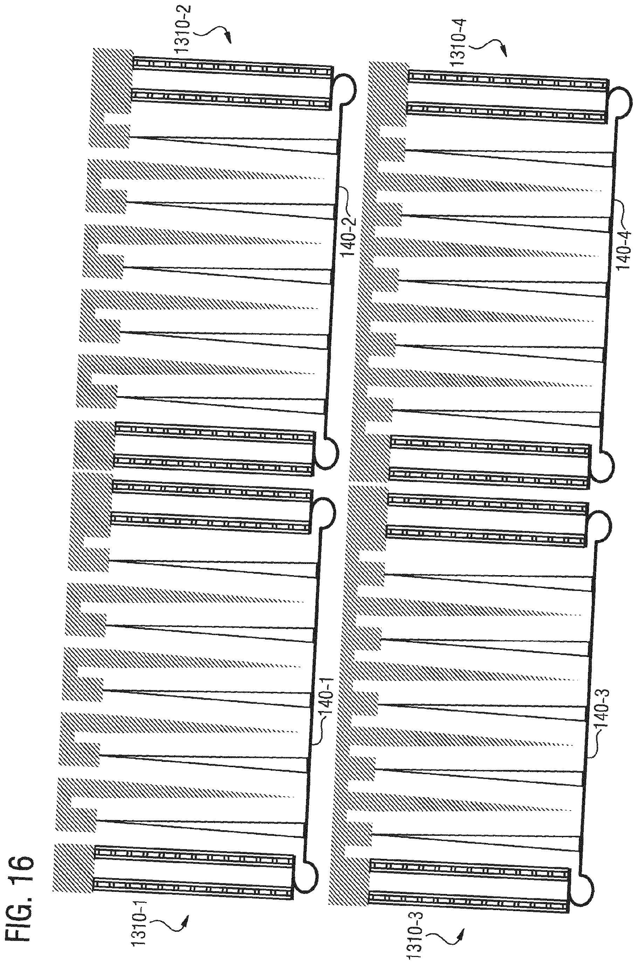

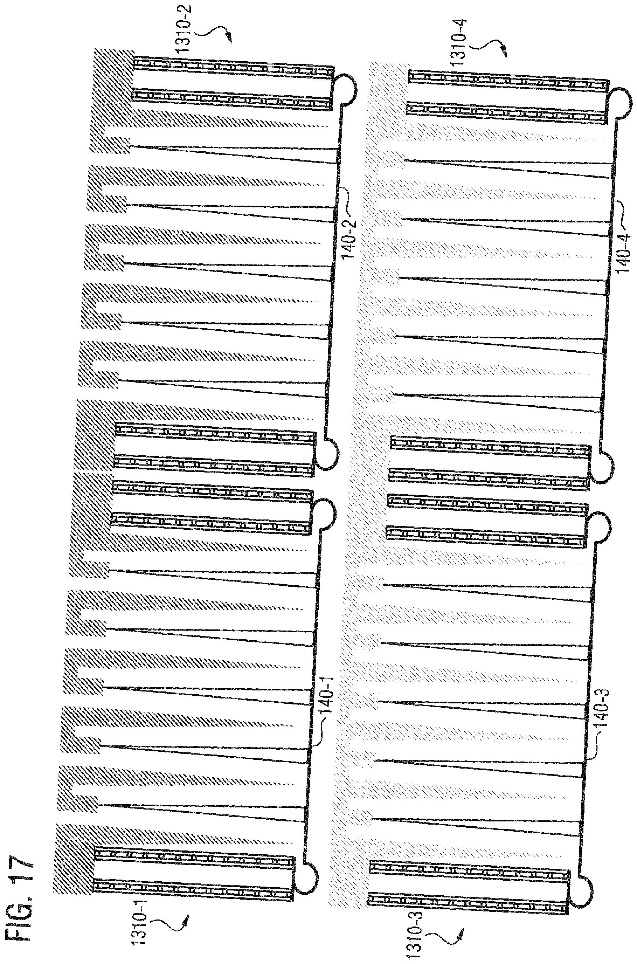

**Fig. 16** zeigt eine Abwandlung der in Fig. 14 gezeigten Anordnung, bei der die MEMS-Bauteile 1310-3 und 1310-4 die gleiche Ausrichtung wie die MEMS-Bauteile 1310-1 und 1310-2 aufweisen. **Fig. 17** zeigt in analoger Weise eine Abwandlung der in Fig. 15 gezeigten Anordnung. Die MEMS-Bauteile 1310-3 und 1310-4 sind somit gegenüber den MEMS-Bauteilen 1310-1 und 1310-2 um 0 ° gedreht in den Ausführungsbeispielen der Figs. 16 und 17. Entsprechend liegen die jeweiligen Verbindungselemente 140-3 und 140-4 der MEMS-Bauteile 1310-3 und 1310-4 nicht den jeweiligen Verbindungselementen 140-1 und 140-2 der MEMS-Bauteile 1310-1 und 1310-2 gegenüber, sondern die Verbindungselemente 140-1 und 140-2 der MEMS-Bauteile 1310-1 und 1310-2 liegen dem Substrat der zweiten Schicht der MEMS-Bauteile 1310-3 und 1310-4 gegenüber.

Gemäß Ausführungsbeispielen kann ein erstes MEMS-Bauteil der Mehrzahl an MEMS-Bauteilen gegenüber einem zweiten MEMS-Bauteil der Mehrzahl an MEMS-Bauteilen auch um einen von 0 ° und 180 ° verschiedenen Winkel gedreht sein. Beispielsweise kann ein erstes MEMS-Bauteil um 90 ° oder einen davon abweichenden Winkel gegenüber einem zweiten MEMS-Bauteil der Mehrzahl an MEMS-Bauteilen gedreht sein. Dies kann vorteilhafterweise eine hohen Flächennutzungsgrad einer zur Verfügung stehenden Bauteilfläche ermöglichen.

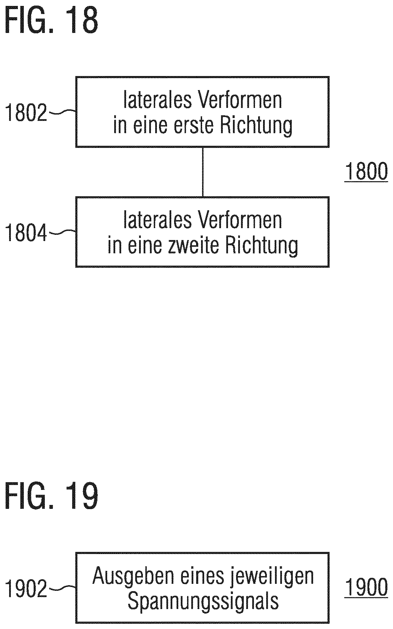

Um die oben beschriebenen Aspekte zum Betreiben der hierin beschriebenen MEMS-Bauteile nochmals zusammenzufassen, sind in den Fig. 18 und 19 noch Ablaufdiagramme zweier Verfahren zum Betreiben der hierin beschriebenen MEMS-Bauteile gezeigt.

**Fig. 18** zeigt ein Ablaufdiagramm eines ersten Verfahrens 1800 zum Betreiben eines hierin beschriebenen MEMS-Bauteils. Das Verfahren 1800 umfasst ein laterales Verformen 1802 der zwei lateral auslenkbaren Elemente in eine erste Richtung durch Anlegen eines Potentials (z.B. eines Spannungssignals), um während eines ersten Zeitintervalls zur Beeinflussung des Umgebungsfluides ein Volumen der einen Teilkavität der benachbarten Teilkavitäten zu vergrößern und ein Volumen der anderen Teilkavität der benachbarten Teilkavitäten zu verringern. Weiterhin umfasst das Verfahren 1800 ein laterales Verformen 1804 der zwei lateral auslenkbaren Elemente in eine entgegengesetzte zweite Richtung durch Anlegen des Potentials, um während eines zweiten Zeitintervalls zur Beeinflussung des Umgebungsfluides das Volumen der einen Teilkavität der benachbarten Teilkavitäten zu vergrößern und das Volumen der anderen Teilkavität der benachbarten Teilkavitäten zu verringern.

Das Verfahren 1800 kann eine kontrollierte Beeinflussung des Umgebungsfluides basierend auf dem angelegten Potential ermöglichen. Aufgrund der kammartigen Anordnung der ersten und zweiten Finger kann die zur Verfügung stehende Fläche des MEMS-Bauteils zu einem hohen Grad für die Beeinflussung des Umgebungsfluid genutzt werden. Das Verfahren 1800 kann für den Betrieb des MEMS-Bauteils als Aktor genutzt werden.

Weitere Details und Aspekte des Verfahrens 1800 sind oben in Zusammenhang mit weiteren Ausführungsbeispielen (z.B. Figs. 1 bis 12) beschrieben. Das Verfahren 1800 kann eines oder mehrere optionale Merkmale gemäß den weiteren Ausführungsbeispielen umfassen.

**Fig. 19** zeigt ein Ablaufdiagramm eines zweiten Verfahrens 1900 zum Betreiben eines hierin beschriebenen MEMS-Bauteils, bei dem sich die Mehrzahl an zweiten Fingern gegenüber der Mehrzahl an ersten Fingern lateral verschieben können, um abhängig von dem Umgebungsfluid Volumina der benachbarten Teilkavitäten unter lateraler Verformung der zwei lateral auslenkbaren Elemente einzustellen. Das Verfahren 1900 umfasst ein Ausgeben 1902 eines jeweiligen Potentials (z.B. eines Spannungssignals) durch die zwei lateral auslenkbaren Elemente bei lateraler Verformung aufgrund der äußeren Krafteinwirkung durch die Verschiebung der Mehrzahl an zweiten Fingern.

Aufgrund der kammartigen Anordnung der ersten und zweiten Finger kann die zur Verfügung stehende Fläche des MEMS-Bauteils zu einem hohen Grad für die Sensierung des Umgebungsfluid genutzt werden. Das Verfahren 1900 kann für den Betrieb des MEMS-Bauteils als Sensor genutzt werden.

Weitere Details und Aspekte des Verfahrens 1900 sind oben in Zusammenhang mit weiteren Ausführungsbeispielen (z.B. Figs. 1 bis 12) beschrieben. Das Verfahren 1900 kann eines oder mehrere optionale Merkmale gemäß den weiteren Ausführungsbeispielen umfassen.

Ausführungsbeispiele der vorliegenden Offenbarung betreffen somit unter anderem:
Ein MEMS-Wandlersystem bestehend aus einer Vielzahl aktiv verformbarer Elemente und eine Vielzahl passiver Elemente, die mit den aktiven Elementen verbunden sind und in der Substratschicht eines zumindest drei schichtigen Stapels angeordnet sind.

Ein MEMS-Wandlersystem bestehend aus mindestens zwei zueinander diskret beabstandeten einseitig eingespannten NED Aktoren, die über einen gemeinsamen Kammrücken miteinander verbunden sind.

Ausführungsbeispiele, in denen eine laterale Verformung einseitig eingespannter Biegewandler basierend auf einem elektrischen Potential erfolgt und aufgrund der Verbindung der aktiv verformbaren Elemente über den Kammrücken die Bewegung gleichsinnig ist.

Ausführungsbeispiele, in denen die Finger mit dem Kammrücken verbunden sind und gemeinsam mit den Gegenfingern, die mit dem Substrat verbunden sind, die Teilkavitäten begrenzen. Weitere Begrenzungen der Teilkavitäten ergeben sich durch den Kammrücken, das Substrat, sowie Deckel- und Handlingwafer.

Ausführungsbeispiele, in denen die Teilkavitäten durch Öffnungen im Substrat und/oder im Deckel- und/oder Handlingwafer mit der Umgebung verbunden sind. Die Öffnungen können im Substrat und im Deckelwafer angeordnet sein. Die Öffnungen können alternativ im Substrat und im Handlingwafer angeordnet sein. Ferner können die Öffnungen im Deckel-und Handlingwafer angeordnet sein.

Ausführungsbeispiele, in denen der Querschnitt der Finger im Bereich der Verbindung mit dem Kammrücken am größten ist und sich zu seinem freien Ende hin verjüngt (Winkel α).

Ausführungsbeispiele, in denen die Querschnitte von einem quadratischen Querschnitt abweichen. Es sind z.B. ovale, spitz zulaufende oder taillierte Querschnitte möglich.

Ausführungsbeispiele, in denen die Finger diskret zueinander beabstandet sind.

Ausführungsbeispiele, in denen der Querschnitt der Gegenfinger im Bereich der Verbindung mit dem Rahmen am größten ist und sich zu seinem freien Ende hin verjüngt.

Ausführungsbeispiele, in denen die Querschnitte der Finger oder Gegenfinger von einem quadratischen Querschnitt abweichen. Es sind z.B. ovale, spitz zulaufende oder taillierte Querschnitte möglich.

Ausführungsbeispiele, in denen die Gegenfinger diskret zueinander beabstandet sind. Der Abstand kann z.B. zwischen 0 und 100 µm, bevorzugt 15 µm und besonders bevorzugt 10 µm betragen.

Ausführungsbeispiele, in denen die Finger sich lateral um 65%, bevorzugt 85% und besonders bevorzugt 95% überlappen.

Die Aspekte und Merkmale, die zusammen mit einem oder mehreren der vorher detaillierten Beispiele und Figuren beschrieben sind, können auch mit einem oder mehreren der anderen Beispiele kombiniert werden, um ein gleiches Merkmal des anderen Beispiels zu ersetzen oder um das Merkmal in das andere Beispiel zusätzlich einzuführen.

Durch die Beschreibung und Zeichnungen werden nur die Grundsätze der Offenbarung dargestellt. Weiterhin sollen alle hier aufgeführten Beispiele grundsätzlich ausdrücklich nur illustrativen Zwecken dienen, um den Leser beim Verständnis der Grundsätze der Offenbarung und der durch die Erfinder beigetragenen Konzepte zur Weiterentwicklung der Technik zu unterstützen. Alle hiesigen Aussagen über Grundsätze, Aspekte und Beispiele der Offenbarung sowie konkrete Beispiele derselben umfassen deren Entsprechungen.

Weiterhin sind die folgenden Ansprüche hiermit in die detaillierte Beschreibung aufgenommen, wo jeder Anspruch als getrenntes Beispiel für sich stehen kann. Während jeder Anspruch als getrenntes Beispiel für sich stehen kann, ist zu beachten, dass - obwohl ein abhängiger Anspruch sich in den Ansprüchen auf eine bestimmte Kombination mit einem oder mehreren anderen Ansprüchen beziehen kann - andere Beispiele auch eine Kombination des abhängigen Anspruchs mit dem Gegenstand jedes anderen abhängigen oder unabhängigen Anspruchs umfassen können. Solche Kombinationen werden hier explizit vorgeschlagen, sofern nicht angegeben ist, dass eine bestimmte Kombination nicht beabsichtigt ist.

## Patentansprüche

1. MEMS-Bauteil, umfassend:
einen Schichtstapel (110) mit zumindest einer zwischen einer ersten Schicht (111) und einer dritten Schicht (113) gebildeten zweiten Schicht (112), wobei in der zweiten Schicht (112) eine Kavität (114) gebildet ist;
zwei lateral auslenkbare Elemente (120, 130), die lateral zueinander beabstandet in der Kavität (114) angeordnet sind, wobei jedes der zwei lateral auslenkbaren Elemente (120, 130) jeweils ein mit einer Seitenwand (115) der Kavität (114) verbundenes Ende (121) aufweist;
ein Verbindungselement (140), das mit den zwei lateral auslenkbaren Elementen (120, 130) verbunden ist, um die Bewegung der zwei lateral auslenkbaren Elemente (120, 130) zu koppeln;
eine Mehrzahl an ersten Fingern (150-1, ..., 150-6), die diskret zueinander beabstandet zwischen den zwei lateral auslenkbaren Elementen (120, 130) an der Seitenwand (115) der Kavität (114) angeordnet sind;
eine Mehrzahl an zweiten Fingern (160-1, ..., 160-5), die diskret zueinander beabstandet zwischen den zwei lateral auslenkbaren Elementen (120, 130) an dem Verbindungselement (140) angeordnet sind und mit der Mehrzahl an ersten Fingern (150-1, ..., 150-6) ineinander greifen, wobei die Mehrzahl an zweiten Fingern (160-1, ..., 160-5) lateral gegenüber der Mehrzahl an ersten Fingern (150-1, ..., 150-6) bei Verformung der zwei lateral auslenkbaren Elemente (120, 130) verschiebbar sind, so dass die Mehrzahl an ersten Fingern (150-1, ..., 150-6) und die Mehrzahl an zweiten Fingern (160-1, ..., 160-5) eine Mehrzahl an volumenveränderlichen Teilkavitäten (116-1, ..., 116-10) innerhalb der Kavität (114) begrenzen,
wobei jede der Mehrzahl an Teilkavitäten (116-1, ..., 116-10) über eine jeweilige Öffnung (170-1, ..., 170-5, 180-1, ..., 180-5) mit einem Umgebungsfluid des MEMS-Bauteils in Kontakt steht, und wobei bei benachbarten Teilkavitäten der Mehrzahl an Teilkavitäten (116-1, ..., 116-10) jeweils die Öffnung (170-1, ..., 170-5) der einen Teilkavität der benachbarten Teilkavitäten in einer anderen Schicht der ersten Schicht (111), der zweiten Schicht (112) und der dritten Schicht (113) als die Öffnung (180-1, ..., 180-5) der anderen Teilkavität der benachbarten Teilkavitäten gebildet ist.

2. MEMS-Bauteil nach Anspruch 1, wobei die Öffnung (170-1, ..., 170-5) der einen Teilkavität der benachbarten Teilkavitäten in der zweiten Schicht (112) gebildet ist und die Öffnung (180-1, ..., 180-5) der anderen Teilkavität der benachbarten Teilkavitäten in der ersten Schicht (111) oder der zweiten Schicht (112) gebildet ist.

3. MEMS-Bauteil nach Anspruch 1, wobei die Öffnung (170-1, ..., 170-5) der einen Teilkavität der benachbarten Teilkavitäten in der ersten Schicht (111) gebildet ist und die Öffnung (180-1, ..., 180-5) der anderen Teilkavität der benachbarten Teilkavitäten in der dritten Schicht (113) gebildet ist.

4. MEMS-Bauteil nach einem der Ansprüche 1 bis 3, wobei das Verbindungselement (140) jeweils über ein flexibles Element (141, 142) mit den zwei lateral auslenkbaren Elementen (120, 130) verbunden ist, wobei das flexible Element (141, 142) eine geringere Steifigkeit als das Verbindungselement (140) und die zwei lateral auslenkbaren Elemente (120, 130) aufweist.

5. MEMS-Bauteil nach einem der Ansprüche 1 bis 4, wobei ein Querschnitt jedes der Mehrzahl an ersten Fingern (150-1, ..., 150-6) von einem mit der Seitenwand (115) der Kavität (114) verbundenen Ende des jeweiligen ersten Fingers zu einem freien Enden (151-1, ..., 151-6) des jeweiligen ersten Fingers hin abnimmt.

6. MEMS-Bauteil nach einem der Ansprüche 1 bis 5, wobei ein Querschnitt jedes der Mehrzahl an zweiten Fingern (160-1, ..., 160-5) von einem mit dem Verbindungselement (140) verbundenen Ende des jeweiligen zweiten Fingers zu einem freien Enden (161-1, ..., 161-5) des jeweiligen zweiten Fingers hin abnimmt.

7. MEMS-Bauteil nach einem der Ansprüche 1 bis 6, wobei die Mehrzahl an ersten Fingern (150-1, ..., 150-6) und die Mehrzahl an zweiten Fingern (160-1, ..., 160-5) sich entlang ihrer Längserstreckung um zumindest 65 % überlappen.

8. MEMS-Bauteil nach einem der Ansprüche 1 bis 7, wobei die Mehrzahl an ersten Fingern (150-1, ..., 150-6) und die Mehrzahl an zweiten Fingern (160-1, ..., 160-5) sich entlang einer Dickenrichtung der zweiten Schicht (112) um zumindest 80 % überlappen.

9. MEMS-Bauteil nach einem der Ansprüche 1 bis 8, wobei ein Verhältnis einer Lateralerstreckung eines Fingers der Mehrzahl an ersten Fingern (150-1, ..., 150-6) zu seiner Längserstreckung größer ist als ein Verhältnis einer Lateralerstreckung eines Fingers der Mehrzahl an zweiten Fingern (160-1, ..., 160-5) zu seiner Längserstreckung.

10. MEMS-Bauteil nach einem der Ansprüche 1 bis 9, wobei der jeweilige laterale Abstand zwischen der Mehrzahl an ersten Fingern (150-1, ..., 150-6) 100 µm oder weniger beträgt.

11. MEMS-Bauteil nach einem der Ansprüche 1 bis 10, wobei ein Verhältnis einer Erstreckung der Mehrzahl an ersten Fingern (150-1, ..., 150-6) und/oder einer Erstreckung der Mehrzahl an zweiten Fingern (160-1, ..., 160-5) entlang einer Dickenrichtung der zweiten Schicht (112) zu einer Erstreckung der zwei lateral auslenkbaren Elemente (120, 130) entlang der Dickenrichtung der zweiten Schicht (112) zwischen 10 % und 100 % beträgt.

12. MEMS-Bauteil nach einem der Ansprüche 1 bis 11, wobei eine Erstreckung der Mehrzahl an ersten Fingern (150-1, ..., 150-6), der Mehrzahl an zweiten Fingern (160-1, ..., 160-5) und der zwei lateral auslenkbaren Elemente (120, 130) entlang einer Dickenrichtung der zweiten Schicht (112) zwischen 10 µm und 750 µm beträgt.

13. MEMS-Bauteil nach einem der Ansprüche 1 bis 12, wobei die zwei lateral auslenkbaren Elemente (120, 130) ausgebildet sind, sich bei Anlegen eines ersten Potentials lateral zu verformen, so dass sich die Mehrzahl an zweiten Fingern (160-1, ..., 160-5) in lateraler Richtung gegenüber der Mehrzahl an ersten Fingern (150-1, ..., 150-6) verschiebt, um zur Beeinflussung des Umgebungsfluid ein Volumen der einen Teilkavität der benachbarten Teilkavitäten abwechselnd zu verringern und zu vergrößern und umgekehrt ein Volumen der anderen Teilkavität der benachbarten Teilkavitäten abwechselnd zu vergrößern bzw. zu verringern.

14. MEMS-Bauteil nach einem der Ansprüche 1 bis 13, wobei sich die Mehrzahl an zweiten Fingern (160-1, ..., 160-5) gegenüber der Mehrzahl an ersten Fingern (150-1, ..., 150-6) lateral verschieben können, um abhängig von dem Umgebungsfluid Volumina der benachbarten Teilkavitäten unter lateraler Verformung der zwei lateral auslenkbaren Elemente (120, 130) einzustellen, und wobei die zwei lateral auslenkbaren Elemente (120, 130) ausgebildet sind, bei lateraler Verformung aufgrund der äußeren Krafteinwirkung durch die Verschiebung der Mehrzahl an zweiten Fingern (160-1, ..., 160-5) jeweils ein zweites Potential auszugeben.

15. MEMS-Bauteil nach einem der Ansprüche 1 bis 14, wobei zumindest eines der zwei lateral auslenkbaren Elemente (120, 130) eine erste Elektrodenschicht und eine zweite Elektrodenschicht, zwischen denen eine nicht-leitende Schicht ausgebildet ist, umfasst, wobei das lateral auslenkbare Element ausgebildet ist:
sich bei Anlegen eines ersten Spannungssignals an die erste Elektrodenschicht und die zweite Elektrodenschicht lateral zu verformen; und/oder
bei lateraler Verformung aufgrund einer äußeren Krafteinwirkung ein zweites Spannungssignal an der ersten Elektrodenschicht und der zweiten Elektrodenschicht zu erzeugen.

16. MEMS-Bauteil nach einem der Ansprüche 1 bis 15, wobei jedes der zwei lateral auslenkbaren Elemente (120, 130) ferner ein freies Ende (122, 132) aufweist, und wobei das Verbindungselement (140) mit den freien Enden (122, 132) der zwei lateral auslenkbaren Elemente (120, 130) verbunden ist.

17. MEMS-Bauteil nach einem der Ansprüche 1 bis 15, wobei jedes der zwei lateral auslenkbaren Elemente (120, 130) jeweils ein mit einer weiteren Seitenwand (115') der Kavität (114) verbundenes weiteres (128, 138) Ende aufweist, wobei die Seitenwand (115) und die weiteren Seitenwand (115') einander gegenüberliegen.

18. MEMS-Bauteil nach einem der Ansprüche 1 bis 16, ferner umfassend:
zwei weitere lateral auslenkbare Elemente (120', 130'), die lateral zueinander beabstandet in der Kavität (114) angeordnet sind, wobei jedes der zwei weiteren lateral auslenkbaren Elemente (120', 130') jeweils ein mit einer weiteren Seitenwand (115`) der Kavität (114) verbundenes Ende aufweist, und wobei das Verbindungselement (140) mit den zwei weiteren lateral auslenkbaren Elementen (120', 130') verbunden ist;
eine Mehrzahl an dritten Fingern (150-1`, ..., 150-6'), die diskret zueinander beabstandet zwischen den zwei weiteren lateral auslenkbaren Elementen (120', 130') an der weiteren Seitenwand der Kavität (114) angeordnet sind;
eine Mehrzahl an vierten Fingern (160-1`, ..., 160-5'), die diskret zueinander beabstandet zwischen den zwei weiteren lateral auslenkbaren Elementen (120', 130') an dem Verbindungselement (140) angeordnet sind und mit der Mehrzahl an dritten Fingern (150-1`, ..., 150-6') ineinander greifen, wobei die Mehrzahl an vierten Fingern (160-1`, ..., 160-5') lateral gegenüber der Mehrzahl an dritten Fingern (150-1`, ..., 150-6') verschiebbar sind, so dass die Mehrzahl an dritten Fingern (150-1', ..., 150-6') und die Mehrzahl an vierten Fingern (160-1', ..., 160-5') eine weitere Mehrzahl an volumenveränderlichen Teilkavitäten (116-1', ..., 116-10`) innerhalb der Kavität (114) begrenzen,
wobei jede der weiteren Mehrzahl an Teilkavitäten (116-1', ..., 116-10`) über eine jeweilige Öffnung (170-1', ..., 170-5', 180-1', ..., 180-5') mit dem Umgebungsfluid in Kontakt steht, und wobei bei benachbarten Teilkavitäten der weiteren Mehrzahl an Teilkavitäten (116-1', ..., 116-10') jeweils die Öffnung (170-1', ..., 170-5 `) der einen Teilkavität der benachbarten Teilkavitäten in einer anderen Schicht der ersten Schicht (111), der zweiten Schicht (112) und der dritten Schicht (113) als die Öffnung (180-1', ..., 180-5') der anderen Teilkavität der benachbarten Teilkavitäten gebildet ist.

19. Baugruppe (1300), umfassend:
eine Mehrzahl an MEMS-Bauteilen (1310) gemäß einem der Ansprüche 1 bis 18; und
eine Steuerschaltung (1320), die eingerichtet ist, zumindest ein erstes Potential für die lateral auslenkbaren Elemente zumindest eines Teils der Mehrzahl an MEMS-Bauteilen (1310) bereitzustellen, um die jeweiligen lateral auslenkbaren Elemente als Aktoren zur Beeinflussung des Umgebungsfluid zu betreiben; und/oder
eine Messschaltung (1330), die eingerichtet ist, zweite Potentiale der jeweiligen lateral auslenkbaren Elemente zumindest eines Teils der Mehrzahl an MEMS-Bauteilen (1310) zu messen, um die jeweiligen lateral auslenkbaren Elemente als Sensoren für das Umgebungsfluid zu betreiben.

20. Baugruppe nach Anspruch 19, wobei ein erstes MEMS-Bauteil der Mehrzahl an MEMS-Bauteilen (1310) gegenüber einem zweiten MEMS-Bauteil der Mehrzahl an MEMS-Bauteilen (1310) um einen von 0° und 180° verschiedenen Winkel gedreht ist.

21. Verfahren (1800) zum Betreiben eines MEMS-Bauteils gemäß einem der Ansprüche 1 bis 18, wobei das Verfahren folgendes umfasst:
laterales Verformen (1802) der zwei lateral auslenkbaren Elemente in eine erste Richtung durch Anlegen eines Potentials, um während eines ersten Zeitintervalls zur Beeinflussung des Umgebungsfluides ein Volumen der einen Teilkavität der benachbarten Teilkavitäten zu vergrößern und ein Volumen der anderen Teilkavität der benachbarten Teilkavitäten zu verringern; und
laterales Verformen (1804) der zwei lateral auslenkbaren Elemente in eine entgegengesetzte zweite Richtung durch Anlegen des Potentials, um während eines zweiten Zeitintervalls zur Beeinflussung des Umgebungsfluides das Volumen der einen Teilkavität der benachbarten Teilkavitäten zu verringern und das Volumen der anderen Teilkavität der benachbarten Teilkavitäten zu vergrößern.

22. Verfahren (1900) zum Betreiben eines MEMS-Bauteils gemäß einem der Ansprüche 1 bis 18, wobei sich die Mehrzahl an zweiten Fingern gegenüber der Mehrzahl an ersten Fingern lateral verschieben können, um abhängig von dem Umgebungsfluid Volumina der benachbarten Teilkavitäten unter lateraler Verformung der zwei lateral auslenkbaren Elemente einzustellen, und wobei das Verfahren folgendes umfasst:
Ausgeben (1902) eines jeweiligen Potentials durch die zwei lateral auslenkbaren Elemente bei lateraler Verformung aufgrund der äußeren Krafteinwirkung durch die Verschiebung der Mehrzahl an zweiten Fingern.

## Claims

1. A MEMS device, comprising:
a layer stack (110) having at least one second layer (112) formed between a first layer (111) and a third layer (113), wherein a cavity (114) is formed in the second layer (112);
two laterally deflectable elements (120, 130) arranged laterally spaced apart in the cavity (114), each of the two laterally deflectable elements (120, 130) each having an end (121) connected to a sidewall (115) of the cavity (114);
a connecting element (140) connected to the two laterally deflectable elements (120, 130) to couple the movement of the two laterally deflectable elements (120, 130);
a plurality of first fingers (150-1, ..., 150-6) arranged discretely spaced apart between the two laterally deflectable elements (120, 130) on the sidewall (115) of the cavity (114);
a plurality of second fingers (160-1, ..., 160-5) arranged discretely spaced apart between the two laterally deflectable elements (120, 130) on the connecting element (140) and engaging with the plurality of first fingers (150-1, ..., 150-6), wherein the plurality of second fingers (160-1, ..., 160-5) is laterally displaceable relative to the plurality of first fingers (150-1, ..., 150-6) upon deformation of the two laterally deflectable elements (120, 130), so that the plurality of first fingers (150-1, ..., 150-6) and the plurality of second fingers (160-1, ..., 160-5) define a plurality of volume-variable sub-cavities (116-1, ..., 116-10) within the cavity (114),
wherein each of the plurality of sub-cavities (116-1, ..., 116-10) is in contact with an ambient fluid of the MEMS device via a respective opening (170-1, ..., 170-5, 180-1, ..., 180-5), and wherein, in the case of adjacent sub-cavities of the plurality of sub-cavities (116-1, ..., 116-10), the opening (170-1, ..., 170-5) of the one sub-cavity of the adjacent sub-cavities is respectively formed in a different layer of the first layer (111), the second layer (112), and the third layer (113) than the opening (180-1, ..., 180-5) of the other sub-cavity of the adjacent sub-cavities.

2. The MEMS device of claim 1, wherein the opening (170-1, ..., 170-5) of the one sub-cavity of the adjacent sub-cavities is formed in the second layer (112) and the opening (180-1, ..., 180-5) of the other sub-cavity of the adjacent sub-cavities is formed in the first layer (111) or the second layer (112).

3. The MEMS device of claim 1, wherein the opening (170-1, ..., 170-5) of the one sub-cavity of the adjacent sub-cavities is formed in the first layer (111) and the opening (180-1, ..., 180-5) of the other sub-cavity of the adjacent sub-cavities is formed in the third layer (113).

4. The MEMS device of any one of claims 1 to 3, wherein the connecting element (140) is respectively connected to the two laterally deflectable elements (120, 130) via a flexible element (141, 142), wherein the flexible element (141, 142) has a lower stiffness than the connecting element (140) and the two laterally deflectable elements (120, 130).

5. The MEMS device of any one of claims 1 to 4, wherein a cross-section of each of the plurality of first fingers (150-1, ..., 150-6) decreases from an end of the respective first finger connected to the sidewall (115) of the cavity (114) toward a free end (151-1, ..., 151-6) of the respective first finger.

6. The MEMS device of any one of claims 1 to 5, wherein a cross-section of each of the plurality of second fingers (160-1, ..., 160-5) decreases from an end of the respective second finger connected to the connecting element (140) toward a free end (161-1, ..., 161-5) of the respective second finger.

7. The MEMS device of any one of claims 1 to 6, wherein the plurality of first fingers (150-1, ..., 150-6) and the plurality of second fingers (160-1, ..., 160-5) overlap by at least 65% along their longitudinal extension.

8. The MEMS device of any one of claims 1 to 7, wherein the plurality of first fingers (150-1, ..., 150-6) and the plurality of second fingers (160-1, ..., 160-5) overlap by at least 80% along a thickness direction of the second layer (112).

9. The MEMS device of any one of claims 1 to 8, wherein a ratio of a lateral extension of a finger of the plurality of first fingers (150-1, ..., 150-6) to its longitudinal extension is larger than a ratio of a lateral extension of a finger of the plurality of second fingers (160-1, ..., 160-5) to its longitudinal extension.

10. The MEMS device of any one of claims 1 to 9, wherein the respective lateral distance between the plurality of first fingers (150-1, ..., 150-6) is 100µm or less.

11. The MEMS device of any one of claims 1 to 10, wherein a ratio of an extension of the plurality of first fingers (150-1, ..., 150-6) and/or an extension of the plurality of second fingers (160-1, ..., 160-5) along a thickness direction of the second layer (112) to an extension of the two laterally deflectable elements (120, 130) along the thickness direction of the second layer (112) is between 10% and 100%.

12. The MEMS device of any one of claims 1 to 11, wherein an extension of the plurality of first fingers (150-1, ..., 150-6), the plurality of second fingers (160-1, ..., 160-5), and the two laterally deflectable elements (120, 130) along a thickness direction of the second layer (112) is between 10µm and 750µm.

13. The MEMS device of any one of claims 1 to 12, wherein the two laterally deflectable elements (120, 130) are configured to deform laterally upon application of a first potential so that the plurality of second fingers (160-1, ..., 160-5) displaces in a lateral direction relative to the plurality of first fingers (150-1, ...., 150-6) to, in order to influence the ambient fluid, alternately decrease and increase a volume of the one sub-cavity of the adjacent sub-cavities and, conversely, alternately increase and/or decrease a volume of the other sub-cavity of the adjacent sub-cavities.

14. The MEMS device of any one of claims 1 to 13, wherein the plurality of second fingers (160-1, ..., 160-5) may displace laterally relative to the plurality of first fingers (150-1, ..., 150-6) in order to adjust volumes of the adjacent sub-cavities depending on the ambient fluid under lateral deformation of the two laterally deflectable elements (120, 130), and wherein the two laterally deflectable elements (120, 130) are configured to respectively output a second potential upon lateral deformation due to the application of external force caused by the displacement of the plurality of second fingers (160-1, ..., 160-5).

15. The MEMS device of any one of claims 1 to 14, wherein at least one of the two laterally deflectable elements (120, 130) comprises a first electrode layer and a second electrode layer between which a non-conductive layer is configured, wherein the laterally deflectable element is configured to:
deform laterally when a first voltage signal is applied to the first electrode layer and the second electrode layer; and/or
generate a second voltage signal at the first electrode layer and the second electrode layer in case of lateral deformation due to an application of external force.

16. The MEMS device of any one of claims 1 to 15, wherein each of the two laterally deflectable elements (120, 130) further comprises a free end (122, 132), and wherein the connecting element (140) is connected to the free ends (122, 132) of the two laterally deflectable elements (120, 130).

17. The MEMS device of any one of claims 1 to 15, wherein each of the two laterally deflectable elements (120, 130) has in each case one further (128, 138) end connected to a further sidewall (115') of the cavity (114), the sidewall (115) and the further sidewall (115') facing each other.

18. The MEMS device of any one of claims 1 to 16, further comprising:
two further laterally deflectable elements (120', 130') arranged laterally spaced apart in the cavity (114), each of the two laterally deflectable elements (120`, 130') respectively having an end connected to a further sidewall (115') of the cavity (114), and wherein the connecting element (140) is connected to the two further laterally deflectable elements (120', 130');
a plurality of third fingers (150-1', ..., 150-6`) arranged discretely spaced apart between the two further laterally deflectable elements (120', 130') on the further sidewall of the cavity (114);
a plurality of fourth fingers (160-1', ..., 160-5') arranged discretely spaced apart between the two further laterally deflectable elements (120', 130') at the connecting element (140) and engaging with the plurality of third fingers (150-1', ..., 150-6'), wherein the plurality of fourth fingers (160-1', ..., 160-5') is laterally displaceable relative to the plurality of third fingers (150-1`, ..., 150-6`), so that the plurality of third fingers (150-1`, ..., 150-6`) and the plurality of fourth fingers (160-1', ..., 160-5') define a further plurality of volume-variable sub-cavities (116-1', ..., 116-10') within the cavity (114),
wherein each of the further plurality of sub-cavities (116-1', ..., 116-10') is in contact with the ambient fluid via a respective opening (170-1', ..., 170-5', 180-1', ..., 180-5`), and wherein, in the case of adjacent sub-cavities of the further plurality of sub-cavities (116-1`, ..., 116-10`), the opening (170-1', ..., 170-5') of the one sub-cavity of the adjacent sub-cavities is respectively formed in a different layer of the first layer (111), the second layer (112) and the third layer (113) than the opening (180-1', ..., 180-5') of the other sub-cavity of the adjacent sub-cavities.

19. An assembly (1300), comprising:
a plurality of MEMS devices (1310) of any one of claims 1 to 18; and
a control circuit (1320) configured to provide at least a first potential for the laterally deflectable elements of at least a portion of the plurality of MEMS devices (1310) to operate the respective laterally deflectable elements as actuators for influencing the ambient fluid; and/or
a measurement circuit (1330) configured to measure second potentials of the respective laterally deflectable elements of at least a portion of the plurality of MEMS devices (1310) to operate the respective laterally deflectable elements as sensors for the ambient fluid.

20. The assembly of claim 19, wherein a first MEMS device of the plurality of MEMS devices (1310) is rotated relative to a second MEMS device of the plurality of MEMS devices (1310) by an angle different from 0° and 180°.

21. A method (1800) of operating a MEMS device of any one of claims 1 to 18, the method comprising:
laterally deforming (1802) the two laterally deflectable elements in a first direction by applying a potential to increase a volume of the one sub-cavity of the adjacent sub-cavities and decrease a volume of the other sub-cavity of the adjacent sub-cavities during a first time interval for influencing the ambient fluid; and
laterally deforming (1804) the two laterally deflectable elements in an opposite second direction by applying the potential to decrease the volume of the one sub-cavity of the adjacent sub-cavities and increase the volume of the other sub-cavity of the adjacent sub-cavities during a second time interval for influencing the ambient fluid.

22. A method (1900) of operating a MEMS device of any one of claims 1 to 18, wherein the plurality of second fingers may laterally displace relative to the plurality of first fingers to adjust volumes of the adjacent sub-cavities depending on the ambient fluid under lateral deformation of the two laterally deflectable elements, and wherein the method comprises:
outputting (1902) a respective potential by the two laterally deflectable elements upon lateral deformation due to the application of external force by the displacement of the plurality of second fingers.

## Revendications

1. Composant MEMS, comprenant :
un empilement de couches (110) ayant au moins une deuxième couche (112) formée entre une première couche (111) et une troisième couche (113), une cavité (114) étant formée dans la deuxième couche (112) ;
deux éléments (120, 130) pouvant être déviés latéralement, qui sont disposés de manière espacée latéralement l'un de l'autre dans la cavité (114), chacun des deux éléments (120, 130) pouvant être déviés latéralement ayant respectivement une extrémité (121) connectée à une paroi latérale (115) de la cavité (114) ;
un élément de connexion (140) connecté aux deux éléments (120, 130) pouvant être déviés latéralement pour coupler le mouvement des deux éléments (120, 130) pouvant être déviés latéralement ;
une pluralité de premiers doigts (150-1, ..., 150-6) disposés de manière discrète et espacée les uns des autres entre les deux éléments (120, 130) pouvant être déviés latéralement sur la paroi latérale (115) de la cavité (114) ;
une pluralité de deuxièmes doigts (160-1, ..., 160-5) disposés de manière discrète et espacée les uns des autres entre les deux éléments (120, 130) pouvant être déviés latéralement sur l'élément de connexion (140) et qui s'engagent les uns dans les autres avec la pluralité de premiers doigts (150-1, ..., 150-6), dans lequel la pluralité de deuxièmes doigts (160-1, ..., 160-5) sont déplaçables latéralement par rapport à la pluralité de premiers doigts (150-1, ..., 150-6) lors de la déformation des deux éléments (120, 130) pouvant être déviés latéralement, de sorte que la pluralité de premiers doigts (150-1, ..., 150-6) et la pluralité de deuxièmes doigts (160-1, ..., 160-5) délimitent une pluralité de sous-cavités (116-1, ..., 116-10) de volume variable à l'intérieur de la cavité (114),
chacune de la pluralité de sous-cavités (116-1, ..., 116-10) étant en contact avec un fluide ambiant du composant MEMS par l'intermédiaire d'une ouverture respective (170-1, ..., 170-5, 180-1, ..., 180-5), et dans lequel, dans le cas de sous-cavités adjacentes de la pluralité de sous-cavités (116-1, ..., 116-10), l'ouverture (170-1, ..., 170-5) de l'une sous-cavité des sous-cavités adjacentes est respectivement formée dans une autre couche de la première couche (111), de la deuxième couche (112) et de la troisième couche (113) que l'ouverture (180-1, ..., 180-5) de l'autre sous-cavité des sous-cavités adjacentes.

2. Composant MEMS selon la revendication 1, dans lequel l'ouverture (170-1, ..., 170-5) de l'une des sous-cavités adjacentes est formée dans la deuxième couche (112) et l'ouverture (180-1, ..., 180-5) de l'autre sous-cavité des sous-cavités adjacentes est formée dans la première couche (111) ou la deuxième couche (112).

3. Composant MEMS selon la revendication 1, dans lequel l'ouverture (170-1, ..., 170-5) de l'une sous-cavité des sous-cavités adjacentes est formée dans la première couche (111) et l'ouverture (180-1, ..., 180-5) de l'autre sous-cavité des sous-cavités adjacentes est formée dans la troisième couche (113).

4. Composant MEMS selon l'une des revendications 1 à 3, dans lequel l'élément de connexion (140) est connecté respectivement par l'intermédiaire d'un élément flexible (141, 142) aux deux éléments (120, 130) pouvant être déviés latéralement, l'élément flexible (141, 142) ayant une rigidité inférieure à celle de l'élément de connexion (140) et des deux éléments (120, 130) pouvant être déviés latéralement.

5. Composant MEMS selon l'une des revendications 1 à 4, dans lequel une section transversale de chacun de la pluralité de premiers doigts (150-1, ..., 150-6) diminue depuis une extrémité du premier doigt respectif connectée à la paroi latérale (115) de la cavité (114) vers une extrémité libre (151-1, ..., 151-6) du premier doigt respectif.

6. Composant MEMS selon l'une des revendications 1 à 5, dans lequel une section transversale de chacun de la pluralité de deuxièmes doigts (160-1, ..., 160-5) diminue depuis une extrémité du deuxième doigt respectif connectée à l'élément de connexion (140) vers une extrémité libre (161-1, ..., 161-5) du deuxième doigt respectif.

7. Composant MEMS selon l'une des revendications 1 à 6, dans lequel la pluralité de premiers doigts (150-1, ..., 150-6) et la pluralité de deuxièmes doigts (160-1, ..., 160-5) se chevauchent d'au moins 65 % le long de leur extension longitudinale.

8. Composant MEMS selon l'une des revendications 1 à 7, dans lequel la pluralité de premiers doigts (150-1, ..., 150-6) et la pluralité de deuxièmes doigts (160-1, ..., 160-5) se chevauchent d'au moins 80 % le long d'une direction d'épaisseur de la deuxième couche (112).

9. Composant MEMS selon l'une des revendications 1 à 8, dans lequel un rapport d'une extension latérale d'un doigt de la pluralité de premiers doigts (150-1, ..., 150-6) sur son extension longitudinale est supérieur à un rapport d'une extension latérale d'un doigt de la pluralité de deuxièmes doigts (160-1, ..., 160-5) sur son extension longitudinale.

10. Composant MEMS selon l'une des revendications 1 à 9, dans lequel la distance latérale respective entre la pluralité de premiers doigts (150-1, ..., 150-6) est de 100 µm ou moins.

11. Composant MEMS selon l'une des revendications 1 à 10, dans lequel un rapport d'une extension de la pluralité de premiers doigts (150-1, ..., 150-6) et/ou d'une extension de la pluralité de deuxièmes doigts (160-1, ..., 160-5) le long d'une direction d'épaisseur de la deuxième couche (112) sur une extension des deux éléments (120, 130) pouvant être déviés latéralement le long de la direction d'épaisseur de la deuxième couche (112) est compris entre 10 % et 100 %.

12. Composant MEMS selon l'une des revendications 1 à 11, dans lequel une extension de la pluralité de premiers doigts (150-1, ..., 150-6), de la pluralité de deuxièmes doigts (160-1, ..., 160-5) et des deux éléments (120, 130) pouvant être déviés latéralement le long d'une direction d'épaisseur de la deuxième couche (112) est comprise entre 10 µm et 750 µm.

13. Composant MEMS selon l'une des revendications 1 à 12, dans lequel les deux éléments (120, 130) pouvant être déviés latéralement sont configurés pour se déformer latéralement lors de l'application d'un premier potentiel, de sorte que la pluralité de deuxièmes doigts (160-1, ..., 160-5) se déplace dans la direction latérale par rapport à la pluralité de premiers doigts (150-1, ..., 160-5)...., 150-6) afin de, pour influencer le fluide ambiant, réduire et d'augmenter alternativement un volume de l'une sous-cavités des sous-cavités adjacentes et, inversement, d'augmenter et/ou de réduire alternativement un volume de l'autre sous-cavité des sous-cavités adjacentes.

14. Composant MEMS selon l'une des revendications 1 à 13, dans lequel la pluralité de deuxièmes doigts (160-1, ..., 160-5) peut se déplacer latéralement par rapport à la pluralité de premiers doigts (150-1, ..., 160-5).150-6) pour régler, en fonction du fluide ambiant, des volumes des sous-cavités adjacentes par déformation latérale des deux éléments (120, 130) pouvant être déviés latéralement, et dans lequel les deux éléments (120, 130) pouvant être déviés latéralement sont configurés pour émettre respectivement un deuxième potentiel en cas de déformation latérale en raison de l'application d'une force extérieure par le déplacement de la pluralité de deuxièmes doigts (160-1, ..., 160-5).

15. Composant MEMS selon l'une des revendications 1 à 14, dans lequel au moins l'un des deux éléments (120, 130) pouvant être déviés latéralement comprend une première couche d'électrodes et une deuxième couche d'électrodes entre lesquelles une couche non-conductrice est configurée, ledit élément pouvant être dévié latéralement étant configuré pour :
se déformer latéralement lorsqu'un premier signal de tension est appliqué à la première couche d'électrodes et à la deuxième couche d'électrodes ; et/ou
générer un deuxième signal de tension à la première couche d'électrodes et à la deuxième couche d'électrodes en cas de déformation latérale en raison de l'application d'une force extérieure.

16. Composant MEMS selon l'une des revendications 1 à 15, dans lequel chacun des deux éléments (120, 130) pouvant être déviés latéralement a en outre une extrémité libre (122, 132), et dans lequel l'élément de connexion (140) est connecté aux extrémités libres (122, 132) des deux éléments (120, 130) pouvant être déviés latéralement.

17. Composant MEMS selon l'une des revendications 1 à 15, dans lequel chacun des deux éléments (120, 130) pouvant être déviés latéralement a respectivement une autre (128, 138) extrémité connectée à une autre paroi latérale (115') de la cavité (114), la paroi latérale (115) et l'autre paroi latérale (115 `) se faisant face.

18. Composant MEMS selon l'une des revendications 1 à 16, comprenant en outre :
deux autres éléments (120`, 130') pouvant être déviés latéralement, qui sont disposés de manière espacée latéralement l'un de l'autre dans la cavité (114), chacun des deux autres éléments (120, 130) pouvant être déviés latéralement ayant respectivement une autre extrémité connectée à une autre paroi latérale (115') de la cavité (114), et dans lequel l'élément de connexion (140) est connecté aux deux autres éléments (120`, 130`) pouvant être déviés latéralement ;
une pluralité de troisièmes doigts (150-1', ..., 150-6') disposés de manière discrète et espacée les uns des autres entre les deux autres éléments (120', 130') pouvant être déviés latéralement sur l'autre paroi latérale de la cavité (114) ;
une pluralité de quatrièmes doigts (160-1', ..., 160-5') disposés de manière discrète et espacée les uns des autres entre les deux autres éléments (120`, 130') pouvant être déviés latéralement sur l'élément de connexion (140) et qui s'engagent les uns dans les autres avec la pluralité de troisièmes doigts (150-1', ..., 150-6`), dans lequel la pluralité de quatrièmes doigts (160-1', ..., 160-5') est déplaçable latéralement par rapport à la pluralité de troisièmes doigts (150-1', ..., 150-6'), de sorte que la pluralité de troisièmes doigts (150-1', ..., 150-6`) et la pluralité de quatrièmes doigts (160-1', ..., 160-5') délimitent une autre pluralité de sous-cavités à volume variable (116-1', ..., 116-10') à l'intérieur de la cavité (114),
chacune de l'autre pluralité de sous-cavités (116-1', ..., 116-10') étant en contact avec le fluide ambiant par l'intermédiaire d'une ouverture respective (170-1', ..., 170-5', 180-1', ..., 180-5`), et dans lequel, dans le cas de sous-cavités adjacentes de l'autre pluralité de sous-cavités (116-1 `, ..., 116-10`), l'ouverture (170-1', ..., 170-5') de l'une sous-cavité des sous-cavités adjacentes est respectivement formée dans une autre couche de la première couche (111), de la deuxième couche (112) et de la troisième couche (113) que l'ouverture (180-1', ..., 180-5`) de l'autre sous-cavité des sous-cavités adjacentes.

19. Ensemble (1300) comprenant :
une pluralité de composants MEMS (1310) selon l'une des revendications 1 à 18 ; et
un circuit de commande (1320) configuré pour fournir au moins un premier potentiel pour les éléments pouvant être déviés latéralement d'au moins une partie de la pluralité de composants MEMS (1310), afin de faire fonctionner les éléments respectifs pouvant être déviés latéralement comme des actionneurs pour influencer le fluide ambiant ; et/ou
un circuit de mesure (1330) configuré pour mesurer des deuxièmes potentiels des éléments respectifs pouvant être déviés latéralement d'au moins une partie de la pluralité de composants MEMS (1310) afin de faire fonctionner les éléments respectifs pouvant être déviés latéralement comme des capteurs du fluide ambiant.

20. Ensemble selon la revendication 19, dans lequel un premier composant MEMS de la pluralité de composants MEMS (1310) est tourné d'un angle différent de 0° et 180° par rapport à un deuxième composant MEMS de la pluralité de composants MEMS (1310),

21. Procédé (1800) pour faire fonctionner un composant MEMS selon l'une des revendications 1 à 18, le procédé comprenant le fait de :
déformer latéralement (1802) les deux éléments pouvant être déviés latéralement dans une première direction en appliquant un potentiel pour augmenter un volume de l'une sous-cavité des sous-cavités adjacentes et pour diminuer un volume de l'autre sous-cavité des sous-cavités adjacentes pendant un premier intervalle de temps pour influencer le fluide ambiant ; et
déformer latéralement (1804) les deux éléments pouvant être déviés latéralement dans une deuxième direction opposée en appliquant le potentiel, afin de diminuer le volume de l'une sous-cavité des sous-cavités adjacentes et d'augmenter le volume de l'autre sous-cavité des sous-cavités adjacentes pendant un deuxième intervalle de temps pour influencer le fluide ambiant.

22. Procédé (1900) pour faire fonctionner un composant MEMS selon l'une des revendications 1 à 18, dans lequel la pluralité de deuxièmes doigts peut se déplacer latéralement par rapport à la pluralité de premiers doigts pour régler, en fonction du fluide ambiant, des volumes des sous-cavités adjacentes par déformation latérale des deux éléments pouvant être déviés latéralement, et dans lequel le procédé comprend :
émettre (1902) un potentiel respectif par les deux éléments pouvant être déviés latéralement lors d'une déformation latérale en raison de l'application d'une force extérieure par le déplacement de la pluralité de deuxièmes doigts.
